(19) Europäisches Patentamt
European Patent Office
Office européen des brevets

(11) **EP 2 876 407 B1**

(12) **EUROPEAN PATENT SPECIFICATION**

(45) Date of publication and mention
of the grant of the patent:
**30.05.2018 Bulletin 2018/22**

(51) Int Cl.:
*G01B 7/02* (2006.01)          *G06F 3/041* (2006.01)

(21) Application number: **14194760.6**

(22) Date of filing: **25.11.2014**

(54) **Capacitive sensing interface for proximity detection**

Kapazitive Messschnittstelle für Näherungserkennung

Interface de détection capacitive pour une détection de proximité

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.11.2013 US 201314089837**

(43) Date of publication of application:
**27.05.2015 Bulletin 2015/22**

(73) Proprietor: **Semtech Corporation
Camarillo, CA 93012 (US)**

(72) Inventors:
• **Nys, Olivier**
**2000 Neuchâtel (CH)**
• **Monney, Pascal**
**San Diego, CA California 92103 (US)**
• **Aebischer, Daniel**
**2074 Marin-Epagnier (CH)**

(74) Representative: **P&TS SA (AG, Ltd.)**
**Av. J.-J. Rousseau 4**
**P.O. Box 2848**
**2001 Neuchâtel (CH)**

(56) References cited:
WO-A1-00/05593          FR-A1- 2 756 048
US-A- 3 761 805          US-A1- 2010 110 040
US-B1- 6 239 788

**Description**

**Field of the invention**

The present invention concerns, in embodiments, capacitive detection in case of proximity sensors, such as used in capacitive touch screens. In particular, the capacitor to detect stands between one electrode of the electronic circuit measuring it and for instance a finger or pen approaching the screen, so that the second electrode may be considered as referred to external ground.

**Description of related art**

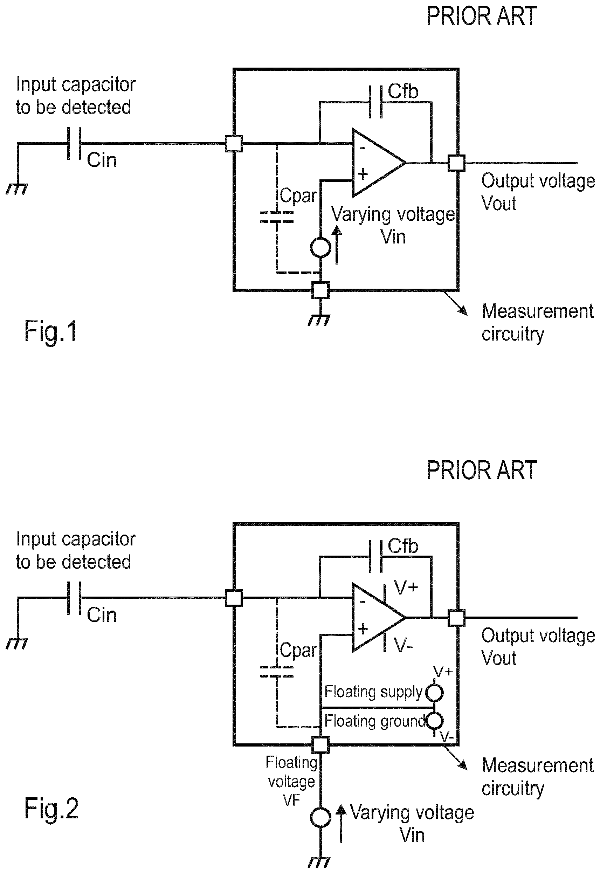

It is known in the art to detect capacitance variations in capacitive elements of touch screens by varying the voltage across them and measuring the charge or current flowing through the element itself. Such an arrangement is illustrated in figure 1. Generally, the measurement circuit is also referred to ground, and the voltage of the capacitive electrode is varied, typically by connecting this electrode to the negative input of an amplifier (virtual ground), and varying the voltage of the positive input. Due to a feedback loop, the negative input voltage will track the positive input. The voltage variation across the capacitor to detect is thus equal to the voltage variation applied between positive input of amplifier and ground. The charge variation or current across the capacitor to detect can thus be estimated by sensing the charge or current sent to the charge amplifier within the circuit. If for instance a capacitor is connected in feedback of the amplifier, then the variation of voltage across this capacitor will be proportional to the charge variation or current, thus representative of the input capacitor to detect.

Assuming that the input capacitor to be detected in this known arrangement is Cin, and the feedback capacitor Cfb, that the voltage variation at inputs and at output of amplifier are respectively $\Delta$Vin and $\Delta$Vout, then the variation of charge on the feedback capacitor is equal to Cfb · ($\Delta$Vout - $\Delta$vin) which should be equal to the charge variation Cin · $\Delta$Vin on the input capacitor. Thus:

$$Cfb\ (\Delta Vout-\Delta Vin) = Cin\ \Delta Vin$$

and

$$\Delta Vout= \Delta Vin\ (\ 1 + Cin/Cfb\ ),$$

yielding in this manner a measurement of the input capacitor Cin.

The problem with this approach is that the measurement is very sensitive to parasitic capacitors. As all the measurement circuit is referred to ground, any parasitic capacitor on chip on the input node is referred to ground and cannot be distinguished from the input capacitor, since the voltage across it varies the same way and the corresponding charge is also injected into the charge amplifier. The voltage variation at the output of the amplifier then becomes:

$$\Delta Vout = \Delta Vin\ (1+ (Cin+Cpar)/Cfb)$$

The measured capacitor is thus not Cin alone but the sum of Cin with all the lumped parasitic capacitors on the input node. If, as it is often the case, the capacitance that must be detected is smaller compared to the undefined parasitic ones, the quality of the measurement is drastically reduced.

To mitigate this issue, patent FR2756048 proposes to refer the whole measurement circuitry to a voltage floating with respect to ground, this floating voltage being generated by a well-defined varying voltage source, as illustrated in figure 2. As all the circuit is referred to the floating voltage VF, the parasitic capacitor Cpar at the input of the amplifier does not see any voltage variation between its electrodes and does not inject any signal, thus does not pollute the measurement. Notice that the circuit of figure 2 requires that the amplifier have floating supply and ground, these voltages being referred to floating voltage VF, as illustrated on the figure.

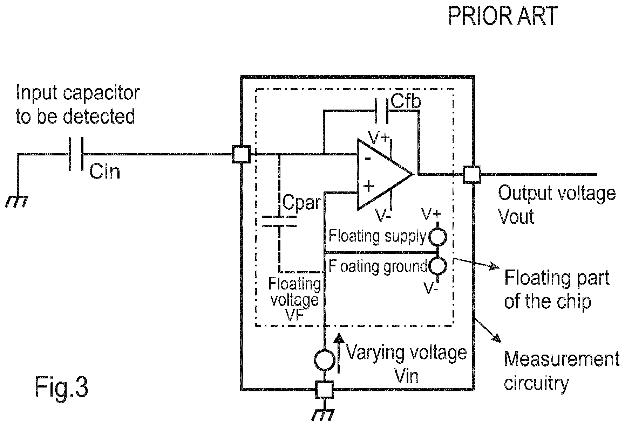

Notice that in a fully integrated approach, the varying voltage between ground and floating voltage could also be taken on board of the chip (or measurement circuitry), as illustrated in figure 3. The chip or measurement circuitry has then not only floating voltage VF but also floating ground voltage. In this case, however, the input stage (related to the external capacitor to detect) should be strongly isolated from the ground voltage in order to avoid parasitic capacitor as in figure 2 between input and ground. All the input stages should be related to VF and the generation of VF with respect to ground should be in a clearly separate part of the chip.

Notice that the connection between the input of the charge amplifier and the capacitor Cin to be detected can be protected by a guard forced to VF or a voltage related to VF in order to avoid parasitic capacitors on this node polluting the capacitor measurement.

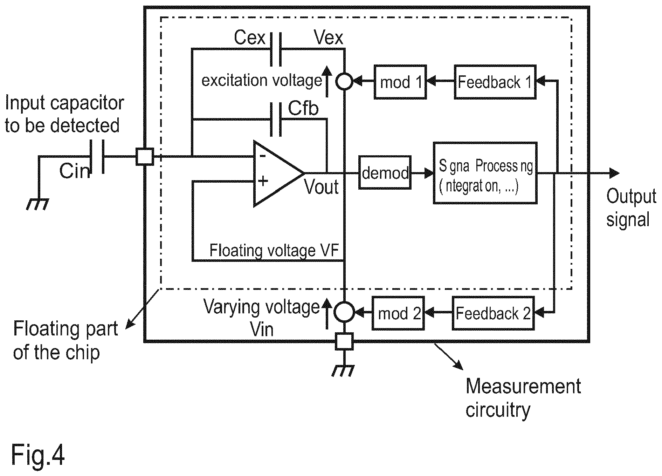

In patent FR2756048, a modulation signal (typically a sinusoid) is applied between ground and floating voltage VF, and the corresponding charge injected through the input capacitor is compensated by a charge injected through another capacitor Cex (excitation capacitor), see figure 4. This excitation capacitor is tied between the virtual ground of the charge amplifier and a node Vex on which a modulation or excitation-signal in opposite phase is applied in order to compensate the charge through Cin, The amplitude of this excitation signal is determined by a feedback loop (feedback 1) and is proportional to the capacitor to detect. The output voltage Vout of the charge amplifier is thus a modulated signal representing the error made on the measurement. By demodulating this signal and by processing the resulting signal, one obtains an output signal representative of the amplitude of the modulation or excitation signal applied on Cex, in order to reduce further the error signal by feedback (feedback 1). In this case, the amplitude of the modulation signal applied in feedback on Cex is proportional to the input capacitor Cin.

In another aspect of patent FR2756048, the amplitude of the modulating signal applied on Cex is fixed but the amplitude of the varying voltage applied between Vf (floating voltage) and ground is changed in feedback (feedback 2), In this case, the amplitude of the modulation signal applied in feedback is a measurement of the inverse of the input capacitor Cin.

Notice that in the arrangement illustrated by figure 4, the charge amplifier must be included in the floating part, while some parts of the other blocks (modulation, demodulation, feedback and signal processing) may at least partially lay outside the floating part.

US2010110040 and US6239788 describe touch controllers connected to a plurality of sensing lines.

US3761805 describes a linear-ramp capacitance meter.

WO0005593 disclose an electrostatic position transducer with capacitive readout.

## Brief summary of the invention

It is difficult to realize a low-power and low-cost implementation of the floating detection circuit that is exemplified in figures 2-4, this due among other reasons to the fact that the generation and monitoring of continuous sinusoidal reference signals requires considerable space and hardware resources. There is therefore a need for a capacitance detection system that allies an excellent rejection of noise with an effective implementation. According to the invention, these aims are achieved by means of the object of the appended claims.

Another aim attained by the claimed invention is the compensation of the noise on the reference voltage, which in turn allows relaxing the requirements on this voltage while still aiming at a high resolution, and have a well-controlled gain for the conversion.

Another aim of this invention is the compensation of systematic offset and perturbations common to all channels, which may be referred to as common mode perturbations.

## Brief Description of the Drawings

The invention will be better understood with the aid of the description of an embodiment given by way of example and illustrated by the figures, in which:

Figure 1 shows schematically a principle of measurement of a capacitance variation;

Figures 2-4 illustrate schematically an arrangement for measuring a capacitance variation in a circuit referred to a floating voltage;

Figure 5 illustrate a detection system according to one aspect of the present invention;

Figures 6a and 6b show, schematically the input and outputs, and corresponding waveforms, of the arrangement illustrated by figure 5;

Figure 7a-d and 8 illustrate schematically the elements that contribute to the proper biasing of the charge amplifier.

Figures 9a-d illustrate schematically the elements that contribute, according to an aspect of the present invention, to the reset of the charge amplifier. Figures 9a-d show in variants in which the reset involves one or several switches in the feedback path of the charge amplifier;

Figures 10 and 11 show the waveforms obtainable by means of the arrangements of figures 9a-9d;

Figures 12a-c show schematically diverse arrangements relating to the power supply of the floating part of the circuit of the invention;

Figures 13a-b illustrate other means of resetting the charge amplifier of the invention;

Figures 14 and 15 illustrate schematically, by using block diagrams, two averaging schemes that can be used in the frame of the invention;

Figure 16 relates to another averaging scheme based on a sigma-delta converter;

Figures 17 and 18 illustrate schematically two manners of combining information relative to rising and falling edges;

Figures 19a and 19b show schematically a sampler suitable for the invention and elements contributing to the filtering of noise;

Figure 20 and 21 a-c show diverse arrangement of flying capacitors that can be used, in the invention, to achieve a supply voltage transformation from the fixed voltage domain towards the floating voltage domain.

Figures 22 a-b illustrate schematically a tandem arrangement of measuring circuits according to a variant of the invention.

Figure 23 shows a system with a plurality of measuring circuits in parallel, for reading the capacity of a grid of electrodes.

Figure 24 illustrates a variant of the invention with a plurality of measuring circuits, one of which being connected to a reference capacity.

Figure 25 shows a variant of the invention in which one measuring channels whose input is tied to a reference capacitor is used to generate a reference voltage for the ADCs in other channels.

Figure 26 shows a model with input capacitors.

Figure 27 illustrates a variant of the invention with a plurality of measuring circuits, one of which is not connected to any input and provides an offset indication that may be subtracted from other channels.

Figure 28 illustrates a variant of the invention with a plurality of measuring circuits, one of which being connected to a reference capacity, and another is not connected to any input.

Figure 29 shows the application of a measuring circuit according to the invention to a capacitive touch-sensitive panel.

## Detailed Description of possible embodiments of the Invention

The main principle of the invention consists into a measurement circuitry for detection of capacitors with respect to ground, in which the input stage is referred to a floating voltage Vf in order to avoid parasitic capacitors with respect to ground, with the following characteristics:

• The modulation signal is a pure square wave signal

• The demodulation is performed by measuring the output voltage of the charge amplifier before and after the edge and performing the difference. This difference, thus the voltage step at the output of the charge amplifier, is proportional to the voltage step applied between Vf and ground (amplitude of the square wave signal) and to the input capacitor Cin, and inversely proportional to the feedback capacitor Cfb.

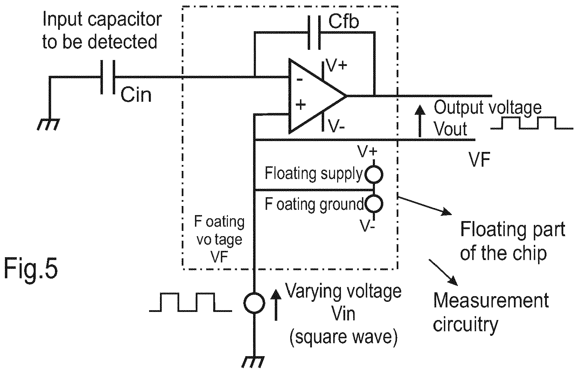

The principle is illustrated in figure 5. The square wave applied between Vf and ground results into square wave signal Vout of same phase between Vout and Vf, and the ratio of output and input amplitudes of square wave is equal to Cin/Cfb. Thus the amplitude of the output square wave is proportional to the input capacitor Cin to detect.

The circuit proposed in figure 5 differs from what is known in particular:

- by the fact that there is no excitation capacitor in the charge amplifier, so no feedback loop, excepted the capacitor Cfb in feedback of the amplifier itself.

- Instead of performing a full modulation and demodulation, only a simple square wave signal is applied, while the demodulation simply consists into measuring the voltage steps amplitude. Thanks to this feature, the output signal does not need any more to be monitored continuously, but can be sampled at well-defined discrete time, making this approach compatible with a switched capacitor implementation. Namely, one measures the output voltage once before a voltage step is applied on floating voltage and once after the voltage step, The second measurement should however wait until the whole input charge has been transferred to the charge amplifier and its output has settled to its final value (or close enough to it).

The present description presents examples of the invention in which the voltage source Vin generates a square voltage. The invention is not however limited to this case and includes also variants in which the voltage generated by Vin has a more complex structure. For example Vin could generate a ternary voltage (either +V, 0, or -V, with sharp transitions therebetween) or exponentially decaying pulses, or any other waveform that exhibiting essentially constant or slow-varying intervals separated by voltage steps.

This main principle will however be completed by several improvements that are presented in the following embodiments of the invention.

Averaging of both edges (rising and falling) of square wave modulation signal

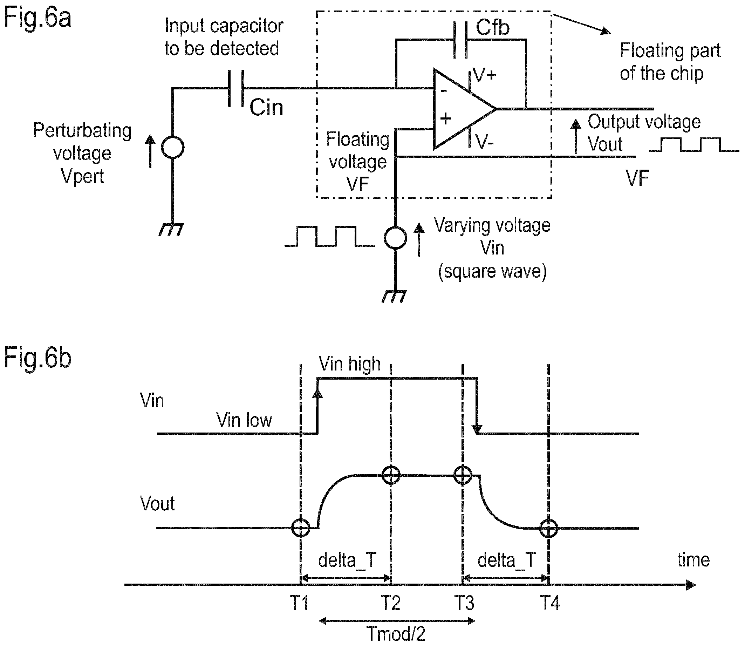

In an improvement of this invention, the measurement is improved by averaging both rising and falling edges of the square wave modulation signal, in order to have a better rejection of low frequency perturbing signals, such as 50 or 60 Hz perturbations. Such a perturbation can be modelled by a voltage source Vpert between ground and the capacitor to detect, see figures 6a, 6b. These figures also show the square wave input signal Vin applied between ground and floating voltage Vf, and the resulting output voltage Vout between output of amplifier and virtual ground. Figure 6b shows two consecutive edges of the modulation signal, and in this example the rising edge is the first one, but the falling edge could also be used.

The output signal is sampled slightly before each edge, and also after the edge, with sufficient delay in order to let the output voltage Vout settle to its final value. For example, as figure 6b illustrates, the samples are taken at time T1 before the rising edge, then at time T2 after the rising edge, then at time T3 before the falling edge and at time T4 after the falling edge. Notice that in a particular case one could have T2 = T3 and the same sample taken after the rising edge and before the falling edge.

Assuming in a first time that there is no perturbation signal, the amplitude of the output signal should be equal to

$$Vout(T2) - Vout(T1) = Vout(T3) - Vout(T4) = (Cin / Cfb) (Vin\_high - Vin\_low) = (Cin / Cfb) \cdot Vin\_square$$

with

$$Vin\_square = Vin\_high - Vin\_low$$

being the amplitude of the square wave input signal.

As Vout(T2) - Vout(T1) = Vout(T3) - Vout(T4), both edges of output signal have the same amplitude and by averaging both output edges, one still obtains the same result, with less noise due to the averaging. Averaging of rising and falling edges is mainly advantageous in order to filter out low frequency perturbation. Let us consider now the effect of the perturbation voltage. In this case, one has

$$Vout(T2) - Vout(Tl) = (Cin/Cfb) (Vin\_square + Vper(T1) - Vper(T2))$$

$$Vout(T3) - Vout(T4) = (Cin/Cfb) (Vin\_square + Vper(T4) - Vper(T3))$$

By averaging:

$$( ( Vout(T2) - Vout(T1)) + ( Vout(T3) - Vout(T4) ) ) / 2 = (Cin/ Cfb ) (Vin\_square + Verror)$$

with

$$Verror = ((Vper(T1) - Vper(T2)) - (Vper(T3) - Vper(T4))) / 2$$

For low frequency perturbation signals, that means for frequencies much lower than the modulation frequency, the slope of the perturbation signal can be considered as approximately constant between two edges of the square modulating signal and one can approximate

$$Vper(T1) - Vper(T2) \approx Vper(T3) - Vper(T4)$$

Provided T2 - T1 = T4 - T3 = $\Delta$T.

Indeed, naming Vper' and Vper" the first and second order derivatives of the perturbing signal, one has

$$Vper(T2) - Vper(T1) \approx Vper'(T1) (T2-T1) \approx Vper'(T1) \Delta T$$

$$Vper(T4) - Vper(T3) \approx Vper'(T3) (T4-T3) \approx Vper'(T3) \Delta T$$

And hence

$$Verror \approx (Vper'(T3) - Vper'(T1)) \cdot \Delta T / 2$$
$$\approx Vper''(T1) (T3-T1) \cdot \Delta T / 2$$
$$\approx Vper''(T1) (Tmod / 2 ) \cdot \Delta T / 2$$

With Tmod/2 being the time between two edges of the square wave input signal, and $\Delta$T being the time between the two samples, before and after each edge, as per figure 6b. The second order derivative Vper" is proportional to the square of the frequency fper of the perturbing signal, thus inversely proportional to the square of its period Tper, while $\Delta$T will be selected as a fraction of the modulation period Tmod = 1 / fmod, with fmod being the modulation frequency (square wave signal). Thus the error term is proportional to the square of the ratio (fper / fmod). This means a strong attenuation of low frequency perturbations (50 or 60 Hz) provided the modulation frequency is much higher than the frequency of the perturbation.

Reset of the charge amplifier

As such, the principle schematic of figure 6 may not work without additional circuitry, since the the virtual ground node is floating, being only tied to capacitors and to the high impedance input of the amplifier. A DC current path should be created towards the virtual ground to avoid amplifier saturation and, preferably, the quiescent output of the amplifiers close to the middle of the output range.

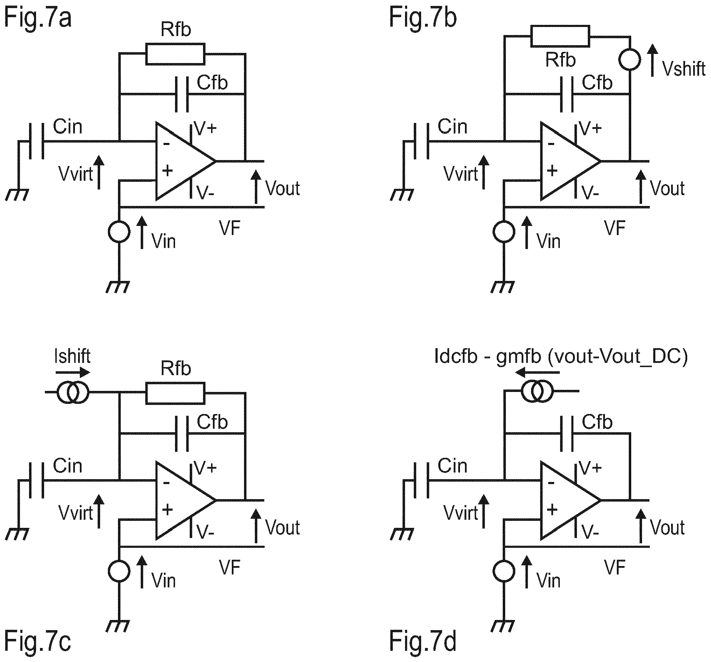

The classical way to achieve this is to have a biasing resistor in feedback of the amplifier, in parallel with Cfb, as illustrated in figure 7 a. In this case, however, the DC component of the output voltage of the amplifier must be equal to the voltage on virtual ground. If the output voltage must be shifted from the input voltage of the amplifier (real of virtual ground), then some voltage shift must be created, either or by means of a current source Ishift = Vshift / Rfb as illustrated in figure 7c or by a voltage source Vshift of value Vvirt - Vout dc on the feedback path (figure 7 b). Vvirt denotes the DC voltage at input of amplifier (real or virtual ground) and Vout_dc the target value of the dc component of output voltage. Another solution is to have a voltage controlled current source injecting on virtual ground a small current proportional to Vou - Vout_dc, which adjusts the voltage on virtual ground until the output voltage Vout is properly centred around the target value Vout dc, see figure 7 d.

With all these solutions, the output voltage of the amplifier tends to a steady state value Vout dc, which is independent of the input signal. The amplifier has thus a high pass filter characteristics, with cut off frequency fc = 1 / (2 $\pi$ Rfb Cfb) (cases of figures 7 a to c) or fc = gmfb / (2 $\pi$ Cfb) (for figure 7 d).

As the signal is transferred at the modulation frequency (frequency of the square wave applied on the floating node Vf), the cut-off frequency of the high-pass filter must be much lower than the modulation frequency. This implies to have either a sufficiently large value of Rb or a sufficiently low value of gmfb. These conditions (large Rfb value or small gmfb value, thus very high impedance on virtual ground) are also favourable in order to limit their contribution to the output noise of the amplifier. But unfortunately they make the system very intolerant to high voltage perturbations such as 50 or 60 Hz perturbations, which can saturate the amplification chain. These perturbations can indeed be of amplitude (typ. 220 V, 380 V) much higher than the supply voltage of the amplifier (maximum a few volts) and can easily saturate the charge amplifier if the peak to peak amplitude of the perturbation multiplied by the gain Cin/Cfb becomes comparable to the output range of the charge amplifier.

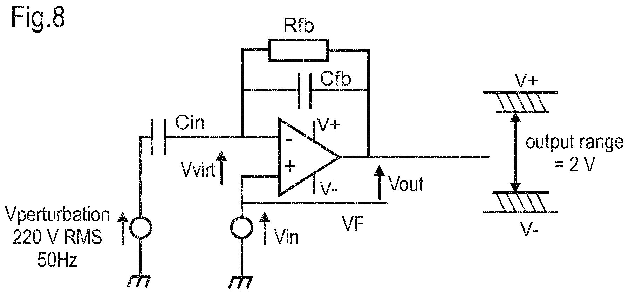

Let us consider for instance figure 8, with a perturbation of amplitude 220 V RMS, thus 622 V peak to peak. And let us also assume by simplification that Cin=Cfb. Assuming that the amplifier has a floating supply voltage of 2 V, this means that the peak to peak voltage must be attenuated by a factor close to 1000, leading to 0.622 V output voltage swing due to perturbation only. This means that the cut off frequency of the high pass filter must be 1000 times higher than the perturbation frequency, thus typically 50 or 60 kHz. And the modulation frequency must be typically again one order of magnitude above the cut-off frequency in order to avoid a significant attenuation due to the high pass filter. This implies a low value Rfb, thus low impedance, and a much higher noise level. There is thus a trade-off between low noise level (requiring high impedance on virtual round) and high robustness with respect to high voltage interferences (requiring low impedance on this node).

In the previous section we saw that a good rejection of the low frequency interferers such as 50 or 60 Hz was achieved by averaging both rising and falling edges of the modulation cycle. This however assumed that the interferers do not saturate the charge amplifier; otherwise there is no more compensation.

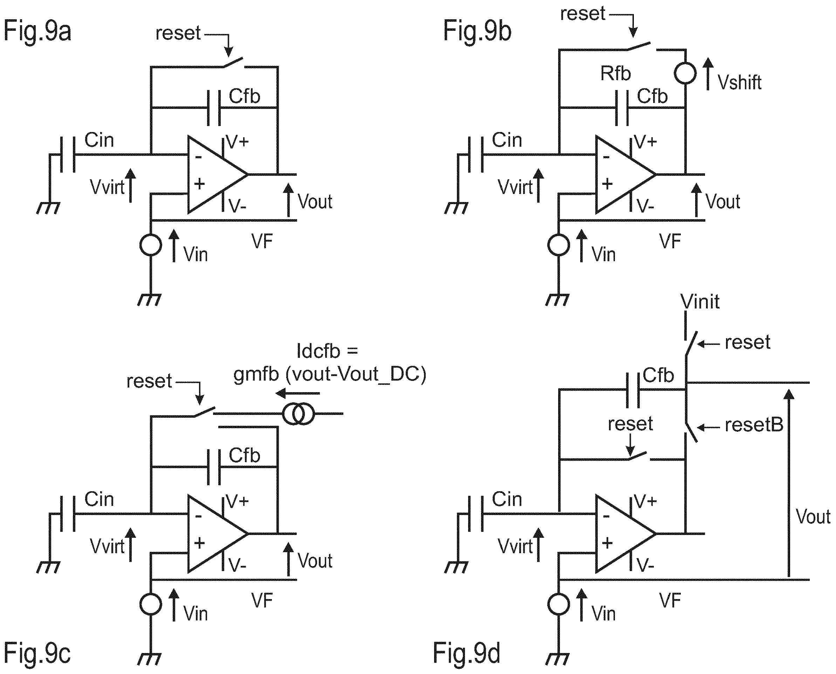

The solution proposed with this invention consists into resetting the charge amplifier before an edge of the modulation signal, by forcing the voltage on the virtual ground and the voltage across the feedback capacitor through one or several switches. This can be achieved by the replacing the feedback resistor Rfb of figures 7a -b by a switch, as illustrated in figure 9a and -b, or by putting a switch in series with the controlled current source gmfb of figure 7d in order to deactivate it when the switch is open, see figure 9c.

Figure 9d is an alternate scheme to figure 9b aiming also to reset the output voltage to a value Vinit different from Vvirt. During the reset phase (reset = '1', resetB = '0') the amplifier has its output shorted to its negative input (virtual ground) while the feedback capacitor Cfb is tied on one side to virtual ground and on the other side to an initialization voltage Vinit. After the reset phase (reset='0', resetB='1') the capacitor Cfb is connected in feedback. Thus just after the reset phase, the output voltage on the second electrode of the capacitor, which is tied to the amplifier output, will remain at a voltage Vinit. Thus the charge amplifier is initialized to a voltage Vinit which may be different from Vvirt.

By using reset switches, a small time constant can be obtained during the reset time, due to the low switch resistance (assuming also a large gmfb in case of figure 9c), leading to a good rejection of the perturbation, while a high impedance, thus a low noise, is obtained afterwards when the switch is opened, due to its very high off resistance. In the particular case of figure 9c the gmfb does not contribute anymore to noise, being disconnected.

Once the reset switch is opened, the circuit becomes sensitive to the perturbation, but only to the variation of the perturbation voltage since the opening of the reset switch. Thus by periodically resetting the amplifier, large perturbations can be tolerated without saturation, provided the variation since the opening of the switch is small enough. Thus maximum tolerance to large perturbations can be obtained by resetting the amplifier at a high frequency, typically before each rising or falling edge of the modulation signal (thus twice the modulation frequency). However, lower frequency of the reset signal could also be possible, (for instance resetting every two edges, every four edges, only before rising edges or before falling edges ..,) though leading to less tolerance with respect to large perturbations.

The charge amplifier is reset in this case between each edge, after the second sample of the previous edge has been acquired (for instance at T2) and before the first sample of the next edge is acquired (for instance at T3). Notice that after the reset has been released, a sufficient time is required in order to let the charge amplifier stabilize before performing the first sample of the next edge. Indeed the operation mode of the charge amplifier is changed by releasing the reset, so some time is required to let it settle to its final value.

Notice also that theoretically assuming that the charge amplifier is reset or initialized to a well-defined output value before each edge, there should theoretically be no need to measure again the voltage before the next edge, as this voltage is not supposed to vary significantly after the reset. The problem is that the reset operation is very noisy due to the thermal noise (kT / C noise due to the input and parasitic capacitors). So that the voltage after the reset is different from the ideal value Vinit, not only due to noise, but also due to charge injection and other parasitic effects. But in fact the initialization voltage does not need to be precise if the output voltage is measured after the reset and before the edge, as the information is only in the amplitude of the edge, and not in the absolute voltages. By performing this double measurement (first sample after the reset and before the edge, and second sample after the edge), the noise contribution of the reset phase is removed, this noise being already taken into account by the first sample and compensated when performing the difference between both samples.

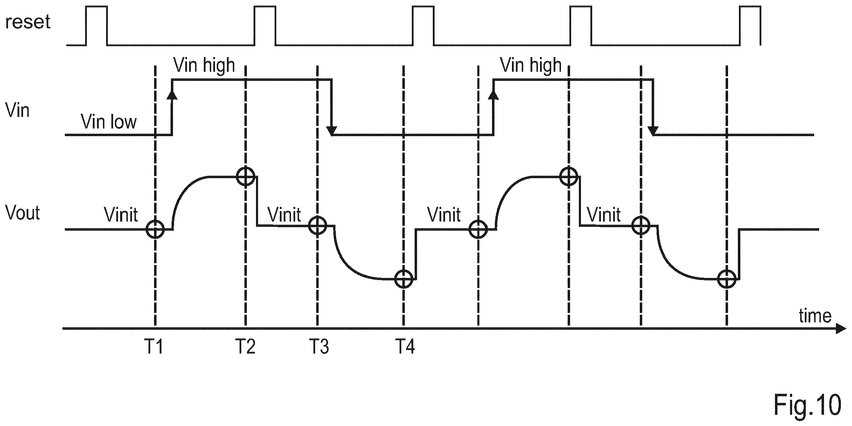

Looking at figure 10, one observes that the output voltage is typically above the initial value Vinit after the rising edge of the modulation signal and below it after the falling edge. Because the rising and falling edges on the output signal may be assumed to be symmetric, the initialization voltage should correspond approximately to the middle of the output range. Assuming a peak to peak output range Vout_pp of the charge amplifier, the amplitude of the edges expected on Vout should thus be lower than Vout_pp / 2 in order not to saturate the charge amplifier, However, in order to maximize the signal-to-noise ratio of the acquisition chain, it is desirable to perform the maximum of gain in the charge amplifier, which is the first stage of the chain, thus maximize the amplitude of edges on Vout, reducing hence the noise contribution of the blocks further in the acquisition chain.

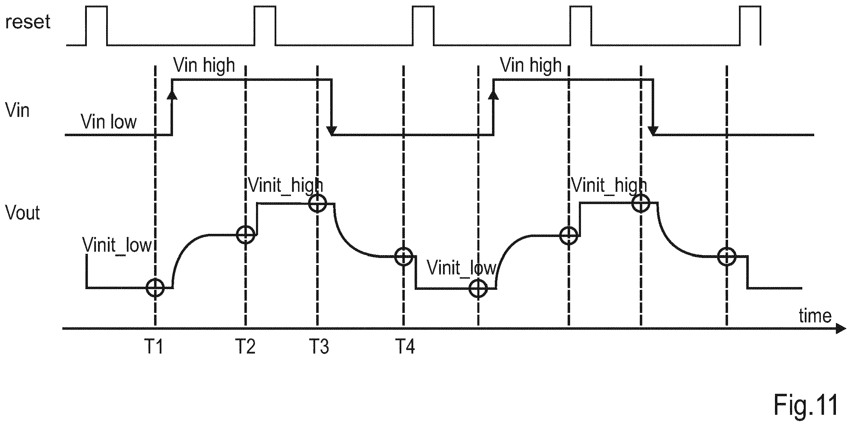

An improvement proposed in this invention report consists into initializing the output of the charge amplifier to different values dependent on the amplitude and/or direction of the modulation steps generated by the voltage source Vin. Indeed, before a rising edge of the modulating signal, the output of the charge amplifier is expected to increase, so it should be initialized rather to a lower value Vinit_low, thus closer to the lower limit of the output range. And conversely, before a falling edge of the modulating signal, the output of the charge amplifier is expected to decrease, so it should be initialized rather to a higher value Vinit_high, closer to the upper limit of the output range. This improvement allows increasing by up to a factor of 2 the gain of the amplifier, thus improving noise performance. It is illustrated in figure 11.

As already pointed out, by using a principle such as illustrated in figures 10 or 11, where the output voltage is measured after the reset, the noise and precision of the reset are not critical. One advantage of this is that it namely allows to connect the positive input of the amplifier directly to one of the supplies (negative or positive supply V- or V+ of the amplifier), thus suppressing the need of a supplementary voltage source and the resulting penalties in terms of additional noise and power consumption.

Let us first consider the schematic of figure 9 d. As such, it would not be possible to connect the positive input of the amplifier (Vf) to one of the supplies V+ or V- of the charge amplifier, for instance V-. Though these amplifiers can have a rail-to-rail common mode input range, the problem is that in the reset phase the input and output are tied together. If the positive input is tied to one of the supplies voltage (V-), the amplifier should thus drive the other input (virtual ground) also to the supply voltage (V-), However, the output stage of the amplifier is not able to drive a voltage up to the supply voltage without saturating, as the output transistors of the amplifier would then enter the linear region, operating in triode mode. (Drain-source voltage Vds close to 0). Thus the amplifier would no more operate correctly when resetting to a voltage close to a supply voltage, its gain falling down abruptly. The negative and positive supplies of the charge amplifier must thus be generated respectively below and above the voltage of the input of the amplifier.

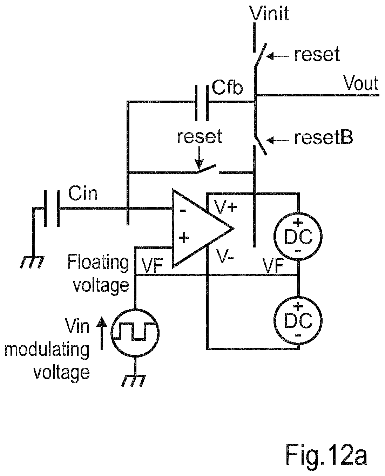

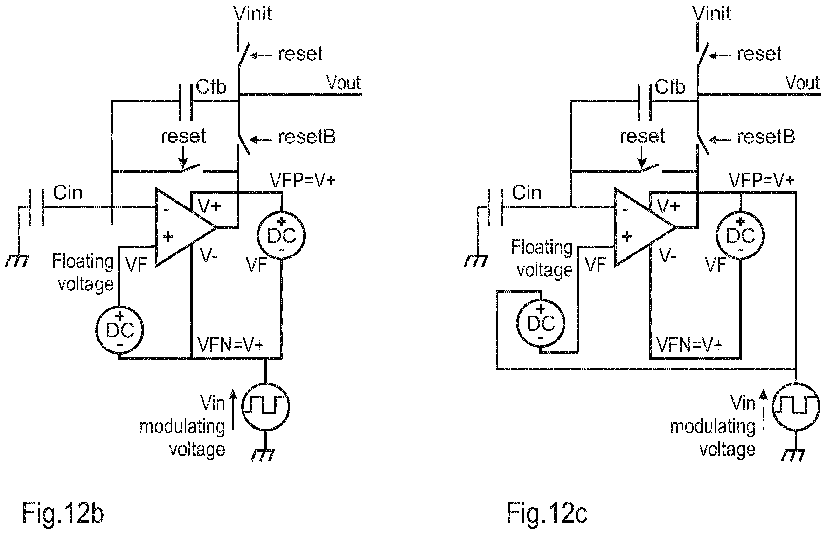

The negative and positive supply voltages may be generated with a fixed voltage difference (DC voltage source), with respect to the floating voltage source, Vf, as illustrated in figure 12 a. Or equivalently, the square wave modulating voltage could be directly applied on the negative supply V- = VfN, and the positive input amplifier and positive supply generated by DC sources, as illustrated in figure 12 b. The modulation voltage could also have been applied directly on the positive supply V+ = VfP and generating positive input of amplifier and negative supply by means of DC sources with respect to VfP, as illustrated in figure 12 c.

Anyway, all these schematics require different voltage sources for positive input as for supplies.

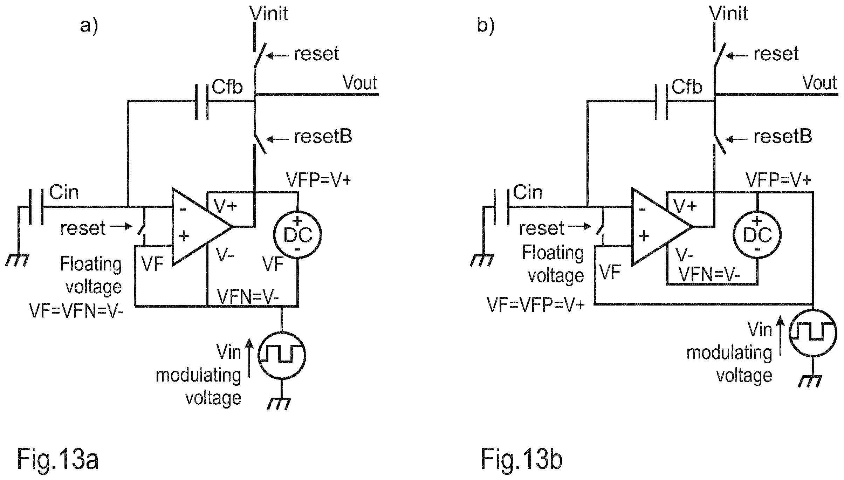

However, as the reset phase is not critical (it should just put roughly the initialization conditions of the charge amplifier, the negative input (virtual ground) can be shorted to the positive input, which can then be one of the supply, while the other side of the feedback capacitor is initialized at the desired value Vinit, as illustrated in figure 13. After the reset, Cfb is reconnected in feedback, being tied to the output of the amplifier.

Ambient noise measurement

The measurement of the capacitors may be affected by ambient noise and perturbing signals. One has already mentioned the low frequency perturbing signals, such as 50 or 60 Hz, and shown that the effect of such signals is at first order compensated by averaging rising and falling edges of the modulation signal. Indeed, the contribution of these perturbations to the capacitor measurement is in opposite phase with respect to the signal for rising and falling edges.

In a first embodiment of this invention, one has means in order to average the rising and falling edges (Vout(T2) - Vout(T1)) and (Vout(T3) - Vout(T4)) of the charge amplifier output signal related to the modulation signals in order to eliminate (or at least strongly attenuate) the effect of low frequency perturbations. This basically corresponds to the operation

$$( (Vout(T2) - Vout(T1)) + (Vout(T3) - Vout(T4)) ) / 2$$

which is equal to

$$( - Vout(Tl) + Vout(T2) + Vout(T3) - Vout(T4) ) / 2$$

as illustrated in figure 6.

In a second embodiment of this invention, one has the option to consider separately only the rising edges or only the falling edges, in order to detect the presence of low frequency noise and evaluate the noise of the environment. In a third embodiment, one has the option to evaluate the difference (or half the difference) of rising and falling edges, instead of the average, in order to have a pure measurement of the low frequency noise perturbation, This basically corresponds to the operation

$$( (Vout(T2) - Vout(Tl)) - (Vout(T3) - Vout(T4) )) / 2$$

which is equal to

$$( - Vout(Tl) + Vout(T2) - Vout(T3) + Vout(T4) ) / 2$$

With this last measurement, the contribution of the capacitor to be detected is eliminated, but the contributions of the low frequency noise at both edges are summed together.

Averaging and Analogue-to-Digital conversion

After the charge amplifier, the output edges should be measured. Different operations remain to be done:

- Averaging of several rising and /or falling edges in order to filter out the noise and limit the bandwidth of perturbations (interferers)

- Convert these edges into digital values representing them.

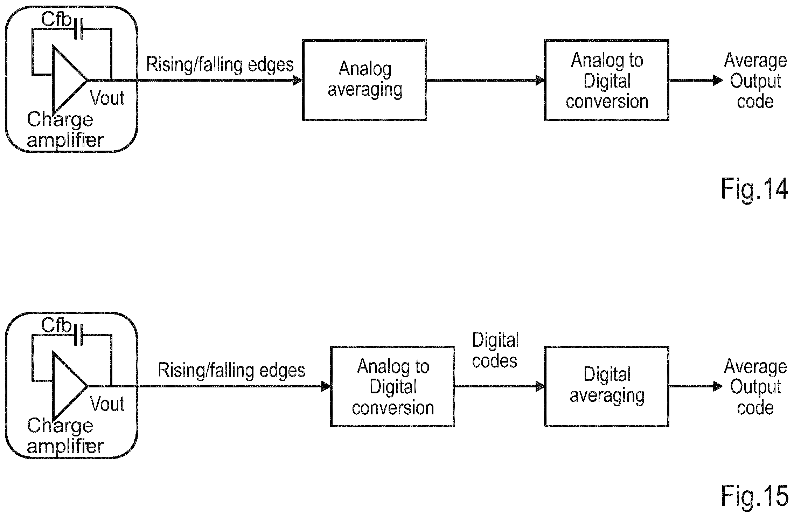

According to this invention, both operations can be performed in any order. In a first implementation (figure 14), the edges can be averaged in an analogue way (typically by switched capacitor circuitry) and the result converted into digital. For instance the different samples are stored on different capacitors which are tied together in order to perform the analogue averaging. The drawback of this solution is however that a large number of capacitors are required if a large number of samples must be averaged, implying a large silicon area. Moreover, a high resolution ADC is required.

In a second implementation (figure 15), the edges are first converted into digital by an ADC and then averaged digitally. In both cases, a high resolution ADC is required.

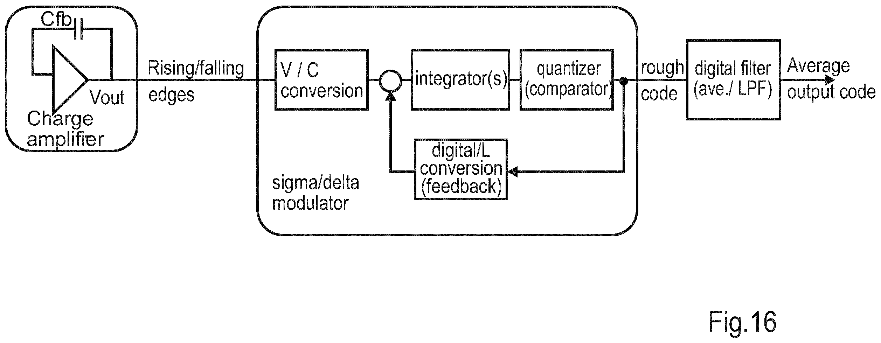

In a third implementation of this invention (figure 16), both operations are performed simultaneously by using a sigma delta converter in order to perform the A/D conversion of the edges. Such a converter converts the successive voltage edges into charges by using a capacitor, at a rate corresponding to the modulation rate, or twice the modulation rates if both rising and falling edges are converted. The corresponding charges $C \cdot \Delta V$ (with $\Delta V$ being the amplitude of the edge) are integrated, typically by mean of a switched capacitor integrator, and then converted by a coarse quantizer (comparator or bank of comparators) into digital codes produced at the same rate as the modulation rate. These codes are then converted back into analogue charges which are subtracted from the input charges corresponding to the output voltage edges. Due to the feedback loop, the charges injected by the feedback path should correspond to the input charges, at least for low frequencies, due to the high gain of the integrator at low frequency. This means that at low frequencies the output codes of the sigma delta loop are representative of the input charges. Thus by filtering or by averaging (averaging corresponding in fact to some special case of filtering) the output code from the sigma delta loop, one obtains a digital output code which is representative of the averaged (or low pass filtered) value of the voltage edges, and thus of the input capacitor.

The averaging and ADC conversion are thus performed simultaneously.

The advantage of this approach is that it does not require very large capacitors in order to accumulate the charge corresponding to the voltage edge. Indeed, as soon as the accumulated charges exceed a given level, a charge corresponding to the output code is subtracted by the feedback path. By this fact, a limited amount of charge is accumulated even after a large number of samples, so that the capacitor sizes can be reduced.

More generally the ADC conversion can be performed by means of any architecture of oversampled ADC converters or sigma delta modulator. Namely but in a non-limiting way, a sigma delta modulator of arbitrary order can be selected. The modulator can have a single loop or different cascaded loops (multistage or Mash sigma delta architectures). The quantization at the output of each sigma delta loop can be single bit or multi-bit, and so on.

Sigma-delta modulators include in general integrators or other state-retention means for storing information. Preferably, all the integrators or the internal variables of the sigma delta modulator used to quantify the edges are reset (or forced to a predetermined value) synchronously with the voltage source Vin before performing the averaging or weighted averaging of the different edges, so that there is no additional errors due to the unknown initial conditions of the measurement. This basically corresponds to the family of the incremental ADC's. In another preferred variant, the states of the integrator(s) or internal variable(s) of the sigma delta modulator are sampled and/or quantified after the last conversion, typically by a supplementary Nyquist rate ADC (such as for instance but not limited to a successive approximation ADC). Indeed the state of the integrator(s) of the sigma delta is some image of the accumulated error. Thus by quantifying the final state of the sigma delta modulator, the estimation of the sigma delta modulator can be further refined.

Notice also that there are two different kinds of averaging.

- The averaging of rising and falling edges

- The averaging of the edges over different modulation cycles.

Here again, these two averaging can be performed into an arbitrary order

For instance, but in a non-limiting way

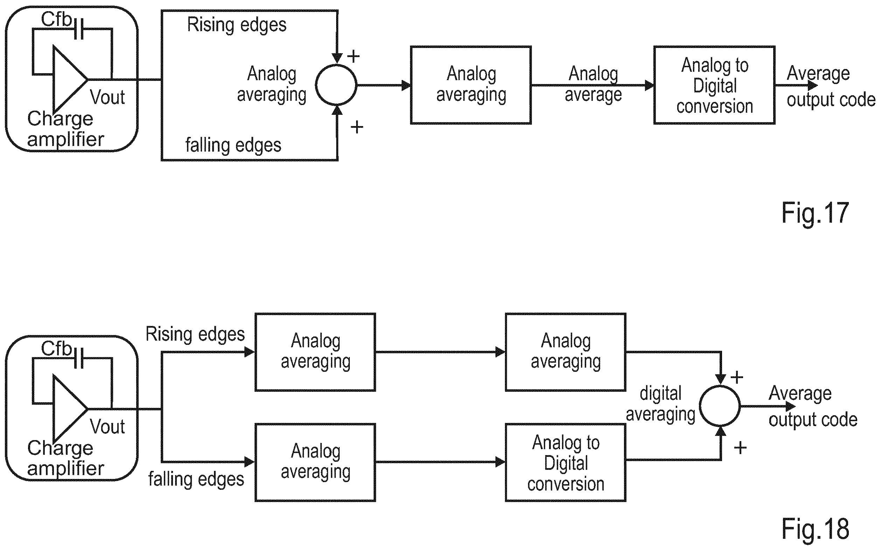

1. one can first average the rising and falling edges for a given modulation cycle, which corresponds to summing up the corresponding charge, and then perform the averaging over several cycles and the ADC conversions by one of the 3 methods described above, as illustrated in figure 17

2. one can process completely separately the rising edges and the falling conversions by one of the 3 methods described above, and then sum up the corresponding results in a digital way, as illustrated in figure 18;

3. the rising and falling edges may also be integrated both within the same sigma delta loop, or by two separate sigma delta loops.

Noise anti-aliasing

In the invention as proposed here above, the output of the charge amplifier is sampled periodically, 2 times per edges, once before the edge and once after the edge, in order to perform the difference. Thus only 2 or 4 samples are available per modulation cycles, according to a single edge is taken into account or both edges. By this fact, noise components at frequencies higher than the modulation frequency may not be distinguished from frequencies below the sampling frequency, due to the well-known aliasing effect. It is thus desirable to eliminate these high frequency noise components before sampling.

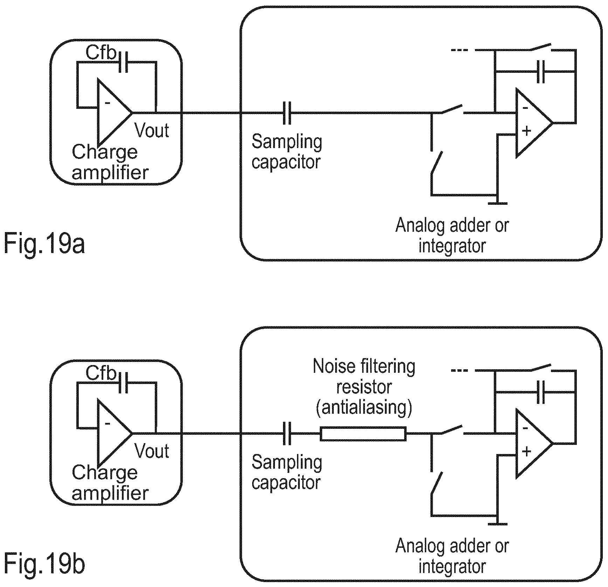

The sampling is basically performed by storing the voltage of the charge amplifier onto a capacitor and freezing the charge stored onto the capacitor by opening a switch, as illustrated in figure 19a. The capacitor on which the voltage is stored is typically the input capacitor of a switched capacitor adder stage (in order to perform analogue summation or averaging) or the input capacitor of a switched capacitor integrator (first stage of a sigma delta modulator).

In a further embodiment of this invention, the high frequency noise components (high frequency environment noise or wide band noise (thermal noise) of the charge amplifier namely) can then be filtered out by inserting a resistive element in series with the sampling capacitor, as illustrated in figure 19b. The value of this resistance should result from a trade-off. A large resistance value filter out most of the noise from the charge amplifier, but will also kill the signal to transfer, as the sampling capacitor has not enough time to be charged or discharged, due to a too large time constant. In a further embodiment of this invention, this resistor can be modified by analogue or digital means, either in a static way or even dynamically during the sampling cycle, in order to have a fast settling after the voltage edge, and a higher time constant before the sampling, in order to better filter out noise.

Extension to multiple capacitive inputs and testability

The principle described above may be generalized to applications for which several capacitive inputs have to be monitored simultaneously. This can be achieved.

- either by using several capacitive acquisition chains in parallel (Parallel approach)

- or by having a single acquisition chain successively scanning different capacitive inputs through an analogue input multiplexer connecting any of the analogue input towards the input (virtual ground) of the charge amplifier (serial approach)

- or by combining both parallel and serial approaches, by having several acquisition chains in parallel, each chain having an input multiplexer in order to successively scan different inputs. For instance 128 capacitive inputs can be monitored by means of 32 acquisition chains in parallel with each acquisition chain addressing successively one capacitive input among 4 through a 4to-1 analogue multiplexer.

However the test of such acquisition chain is painful and time consuming because it depends on external capacitors which are difficult to control precisely and moreover the parasitic interconnections may not easily be distinguished from the controlled input capacitance.

Different possibilities exist in order to facilitate the test, all proposed methods being based on using internal test capacitors in order to emulate the external capacitors. These capacitors can be

- either shared (multiplexed) between the different acquisition chains or channels. The drawback being that the different channels must then be tested one after the other, increasing the test time, but the advantage being that all the channels share a common reference, allowing a better comparison between the different channels

- or having a test capacitor per channel. In this case the test time is faster, but the test capacitors of the different channels may differ due to mismatches.

Now the input of the charge amplifier is a charge, thus in test mode the charge is the product of a test capacitor by a voltage. The test charge can thus be varied:

- either by varying the capacitor, typically by having a digitally programmable test capacitor array, with for instance a first part tied between charge amplifier input and the ground voltage or any fixed voltage with respect to ground, and a second part tied between the charge amplifier input and any floating voltage (such as Vf, VfP, VfN...). The first part of the test capacitor array sees a voltage change across its electrodes when a step is applied on the modulation signal, and thus contributes to the charge transfer while the second part does not. Another possibility to make the capacity digitally programmable is to have only some of the elementary capacitors tied to the electrodes, the other being disconnected from at least one of the electrodes or both. The capacitance could also be varied in some particular cases by varying a control analogue voltage, such as in varicaps.

- or by applying a variable voltage across the test capacitor, for instance by varying the amplitude of the square wave (modulating) voltage between ground and Vf. One can also switch the test capacitors between two nodes related to the floating nodes (constant voltages with respect to Vf, VfP, VfN, and so on) but having a variable voltage difference between them in order to vary the input charge.

- of course one can also combine both approaches, thus varying the capacitor and varying the voltage step across it in order to vary the charge.

Generation of the floating voltage source between VfP and VfN

According to another variant, the invention comprises a floating unipolar or bipolar power supply for the charge amplifier, for example based on flying capacitors that are switched in a cycle comprising in general at least a charge phase, in which the flying capacitor is tied to a power supply and a supply phase in which the flying capacitor is isolated from said power supply and generates the floating power supply.

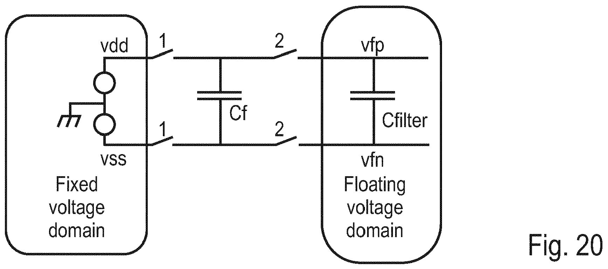

In order to work properly, the described invention requires that the input stage (charge amplifier at least) is supplied with completely floating voltage sources with respect to the ground, but fix voltage with respect to Vf or VfN, as illustrated namely in previous 2, 3, 5, and 12. A first solution to realize this is to use a flying capacitor Cf, which is connected during one phase (phase 1 in figure 20) to supplies related to ground (for instance Vss and Vdd), thus non floating supplies, and during a second phase (phase 2 in figure 20) to the supplies in the floating domain, such as VfN and VfP. A filtering capacitor Cfilter has been added in order to memorize the floating voltage. Hence, according to the example of figure 20, capacitor Cf is pre-charged to a voltage difference Vdd - Vss during phase 1, and put in parallel with Cfilter during phase 2, so that there is a charge redistribution between Cf and Cfilter. At equilibrium, if the capacitors are large enough and switched at a high enough frequency for the current consumed from Vfp and Vfn supplies, the voltage across Cf does not change significantly between both phases, and thus remains close to Vdd-Vss, the voltage stored during phase 1. By consequence Vfp - Vfn is close to Vdd-Vss: the voltage difference between Vdd and Vss is copied between Vfp and Vfn, though these two last voltages are floating.

This circuit may be understood as a fixed-to-floating transformer (or non-floating-to-floating transformer) with transformation ratio of 1. The amplitude of the ripple on Vfp - Vfn is inversely proportional to Cfilter and fsw, while the impedance is inversely proportional to Cf and fsw, with fsw being the switching frequency of the transformer. Most of the time, Cf can be selected relatively small by choosing a high switching frequency.

Without departing from the scope of the present invention, the flying capacitor and the set of four switches connecting it to Vdd, Vss, Vfp and Vfn could be replaced by a capacitive voltage multiplier or divider. For instance, one could also realize a voltage doubler by connecting two different capacitors Cf1 and Cf2 in parallel between Vdd and Vss during phase 1, and connecting both capacitors in series between Vfn and Vfp in phase 2 in order to obtain a (Vfp- Vfn) voltage equal to twice (Vdd - Vss). A voltage tripler could be used using the same principle with 3 capacitors instead of 2. By connecting the capacitors in series between Vdd and Vss and in parallel between Vfp and Vfn, it is possible to attain voltage reductions by a factor 2 or 3. These are just examples, but many architectures achieving different voltage ratios (for instance 2/3, 3/2, 3/4, 4/3, ...) may also be used in order to perform the non-floating to floating voltage conversion.

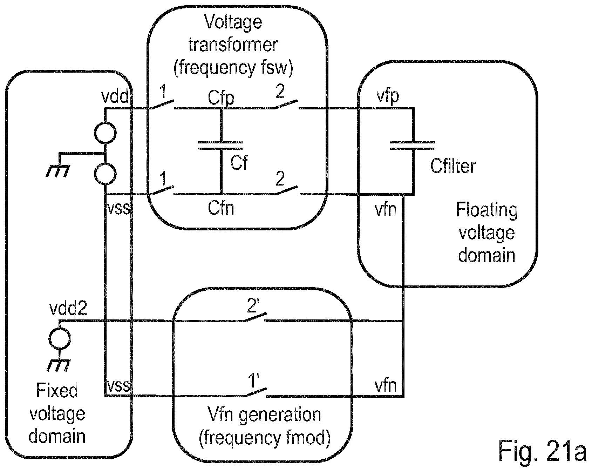

Let us now consider again figure 20, with the transformer switched at frequency fsw (phases 1 and 2) and one of the floating voltages, for instance Vfn, is modulated by a square wave at the modulation frequency fmod (phases 1' and 2'), switching between two voltages of the fixed domain, such as Vss and Vdd2, as illustrated in figure 21a. Notice that Vdd2 can be the same voltage as Vdd, as well as it can be a different one.

Let us now moreover assume

    1. that the switching frequency fsw of the transformer has been selected the same as the modulation frequency,

    2. that phases 1 and 1' coincide,

    3. that phases 2 and 2' coincide.

    4. that the modulation voltage (Vfn) and the electrode of capacitor Cf that is tied to it in phase 2 (Cfn) are connected during phase I to the same node (Vss) as illustrated in figure 21a.

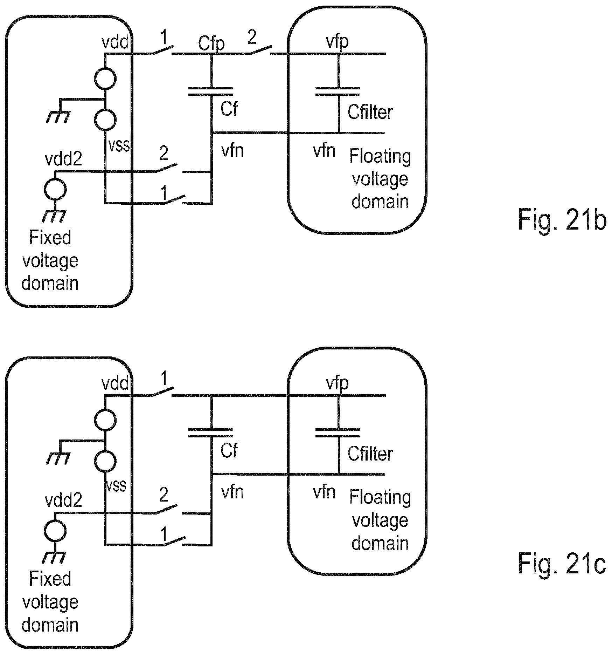

Under these assumptions, and according to figure 21a, one can observe that the negative electrode Cfn of the capacitor and the node Vfn are always tied together through switches. By consequence they can be tied together directly and hence both switches connecting Cfn either to Vss or to Vfn may be suppressed, as represented in figure 21b.

Now considering figure 21b, the voltage across the filtering capacitor Cfilter and flying capacitor Cf should correspond to Vdd-Vss in both phases. Thus during phase 1, as Vfn is tied to Vss, Vfp should be at a voltage corresponding to Vdd. As the voltage on top electrode Cfp of the floating capacitor Cfp is also tied to Vdd at this time, and as Cfp and Vfp are tied together during phase 2, one can observe that Cfp and Vfp are always at the same voltage and thus Cfp may be tied to Vfp, resulting into the circuit of figure 21c, The whole filtering capacitor is thus directly recharged to Vdd - Vss during phase 1, and acts as a supply voltage source during phase 2 in order to memorize the supply voltage.

Notice that as Cf is directly in parallel with Cfilter, it can be replaced by a single (eventually of higher value) capacitor, allowing sparing one component. This implementation should also be part of the invention.

As already mentioned, the simplification proposed here above implies that the switching frequency of the transformer must be selected the same as the modulation frequency, which could limit the impedance, as the impedance is inversely proportional to this switching frequency.

However the single resulting capacitor now not only plays the role of filtering capacitor (Cfilter) but also of flying capacitor Cf which is extremely favourable in order to lower the impedance. Thus by selecting a high enough capacitor, one can simultaneously obtain a low ripple and low impedance, though the switching frequency is limited to the modulation frequency.

Of course a similar approach could have been obtained by switching the node Vfp between two different fixed voltages, for instance Vdd and Vss2, and having the capacitor Cfilter pre-charged between one Vdd and one Vss during one phase and the electrode Vfn being disconnected from the fixed voltage domain during the other phase.

The invention also includes implementations in which the supply voltage is further regulated, namely in order to attenuate the ripple on the Cfilter capacitor due to its discharge caused by the current consumption of the circuit. For instance, the voltage Vfp generated with respect to Vfn may be regulated into a voltage Vfpr, more constant with respect to Vfn.

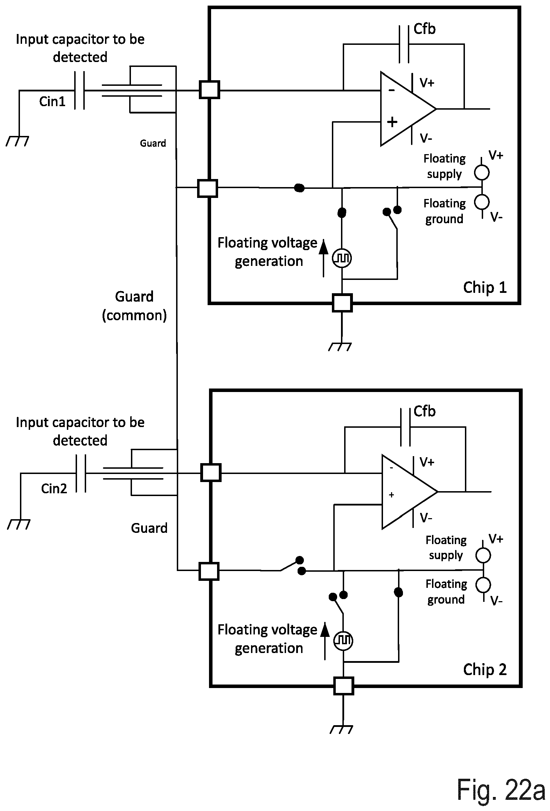

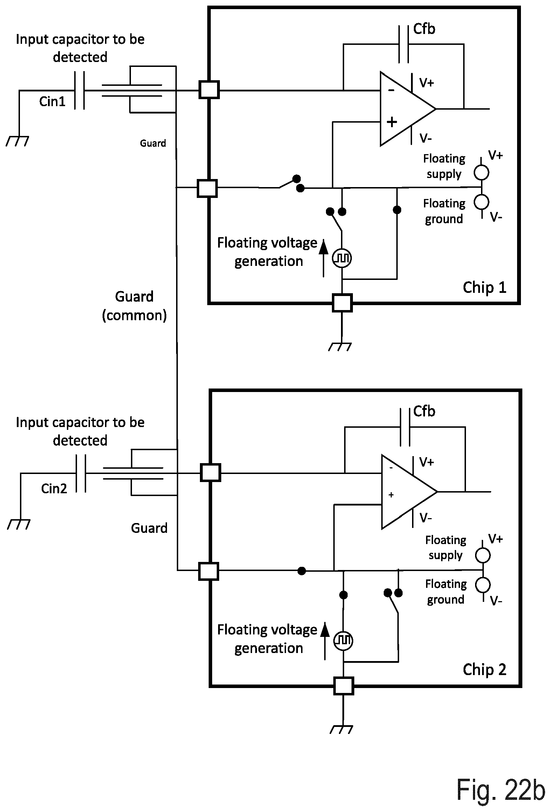

Preferably, the measuring circuit of the invention comprises also a guard output (visible in figures 22a and b) that is connected to a suitable guard conductor for screening the connection between the measuring circuit and the measuring electrode and minimize parasitic couplings.

### Tandem arrangement

Figures 22 a and b illustrate a variant of the invention in which an arbitrary number (here 2 to simplify the drawings) of the measuring circuit of the invention can be operated in tandem by foreseeing a selectable high-impedance state for the voltage source Vin. In this case, a measuring system could, if necessary, include two or several measuring circuits (Chip 1, Chip 2) each connected to a variable capacity Cin1, Cin2 or to a group of variable capacities, that are activated sequentially and one at a time for measuring the capacities connected at the respective inputs. The variable voltage of the floating domain is therefore determined by the voltage source of the circuit that is active at any given instant, whereby the variable voltage sources of the circuits that are not active are set in the high-impedance state.

Figure 22a illustrates the case in which the circuits 'Chip 1' and 'Chip 2' are connected in tandem for reading the capacities Cin1 and Cin2, with the guard terminals in parallel. 'Chip 1' is active, and reads the capacity Cin1. The floating voltage source of Chip 1 is active and determines also the potential of the guard electrodes. Chip 2 is inactive, its internal voltage source and its guard terminal are in a high-impedance state. Figure 22b shows the opposite situation in which Chip 2 is active and reads the capacity Cin2, while Chip1 is in the inactive, high-impedance state.

### Channel compensation

The present invention includes also embodiments that allow an improved and more precise detection of variations in the value of an external capacitor Cin (such as a change caused by the proximity of a finger in the case of a touch-sensitive interface) with respect to an external ground, by using special noise compensation techniques that allow accounting for variations of gain and offset in a plurality of channels, and also a measure of noise rejection, as it will be explained in the following.

The channel compensation can usefully be coupled with the sampling that was discussed in relation to the previous embodiment, in which the excitation voltage has steps and the output signal is sampled synchronously with the excitation voltage, for example before and after each step. They could however be used as well with different sampling units implementing other sampling schemes, and with excitation voltages of any waveform.

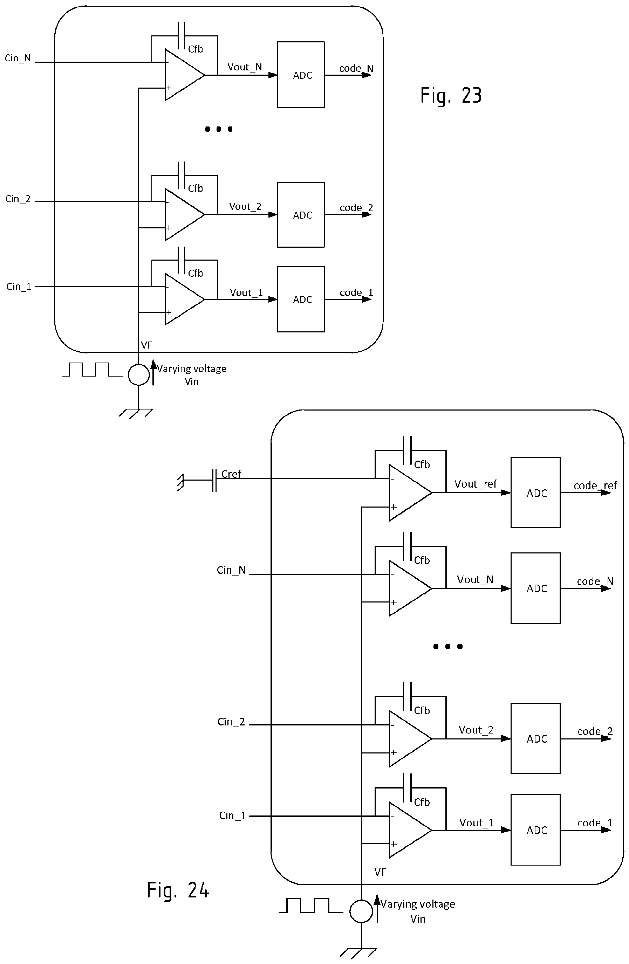

The invention assumes that the circuit has several parallel channels in order to be able to measure several input capacitors simultaneously, as is generally true for capacitive touch screens. This is illustrated in figure 23, which represents a circuit made of N channels in parallel, sampling N capacitive inputs Cin_1, Cin_2, ... Cin_N, modulating the floating voltage VF applied to positive inputs of charge amplifier, then detecting the charge variations through the changes in Vout_k outputs of the charge amplifiers and eventually converting these voltages in digital codes through ADC

$$\text{Code} = k * \text{Vin\_ad} / \text{Vref\_ad}$$
$$= k\,\Delta\text{Vout}/\text{Vref\_ad}$$

$$= k\ (\text{vref}/\text{Vref\_ad})\ \text{Cin}/\,\text{Cfb}$$

### Gain compensation

In a possible embodiment of the invention, the circuit has several parallel channels as illustrated in figure 23, one of which is used as a reference channel connected to an internal or external capacitor Cref as illustrated in figure 24. This channel can be a supplementary channel, explicitly designed and included for the purpose of providing such a gain compensation reference, or one general-purpose channel that is sacrificed to this end. The measurement of this channel, ΔVout_ref or code_ref, is thus proportional to Cref. Thus similarly as for the other channels :

$$\Delta\,\text{Vout\_i} = \text{vref}\,\text{Cin\_i} / \text{Cfb}$$

$$\Delta\,\text{Vout\_ref} = \text{vref}\,\text{Cref} / \text{Cfb}$$

and

$$Code\_i = k \ (vref/Vref\_ad) \ Cin\_i \ / \ Cfb$$

$$Code\_ref = k \ (vref/Vref\_ad) \ Cref \ / \ Cfb$$

The dependency on Vref, Vref_ad and other parameters common to all the channels and defining their gain can then be eliminated by computing the ratio of the measurement on any channel over the measurement of the reference channel.

$$\Delta Vout\_i \ / \ \Delta Vout\_ref = Cin\_i \ / \ Cref$$

or

$$Code\_i \ / \ Code\_ref = Cin\_i \ / \ Cref.$$

The result is thus simply a measurement of Cin_i/Cref, and does not depend any more on vref, vref_ad... . By this fact, the noise contribution of Vref, vref_ad to the measurement is eliminated. The advantage is that the precision and noise specifications on the reference voltage are then drastically relaxed. The quotients code_i/code_ref can be computed in straightforward way in the digital part.

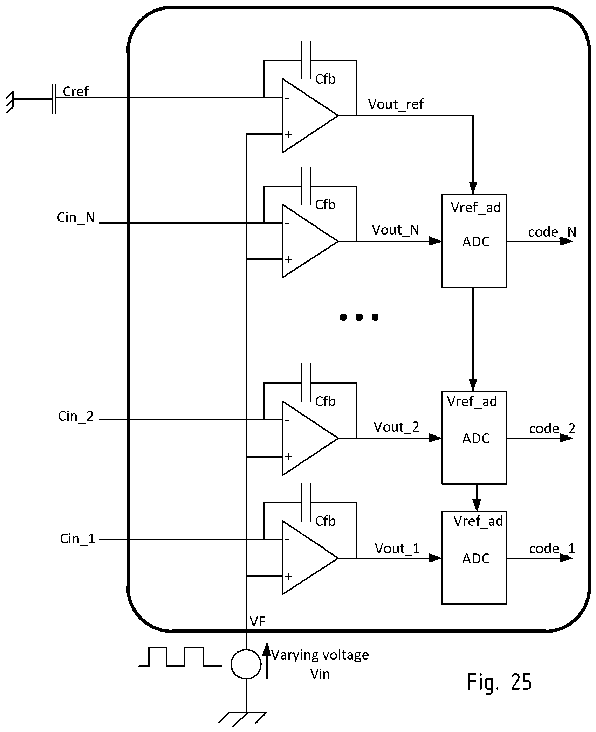

The quotient $\Delta Vout\_i \ / \ \Delta Vout\_ref$ can also be computed by any analog means performing a division. Another possibility to compute this difference is to use an ADC for each output excepted for the reference channel, and use the voltage $\Delta VOUT\_ref$ generated by the integrator of the reference stage as reference voltage for the ADC on the other measurement channels. Since the codes generated by the ADCs are proportional to the input signal and inversely proportional to the voltage used as reference, this arrangement, schematically represented in figure 25, provides the desired compensation by analog means.

Offset compensation

According to a further embodiment, the invention uses a supplementary channel (or sacrifices an existing channel) disconnected from any external capacitor in order to provide offset cancellation. Such channel may be used in order to remove offset sources and perturbations, which are systematic and identical to all channels. These offset sources and perturbations may be of different natures. Some examples are charge injection, which should be the same for every channel, assuming the switches responsible of this charge injection are matched from one channel to another. Other examples may be due to power supply perturbations.

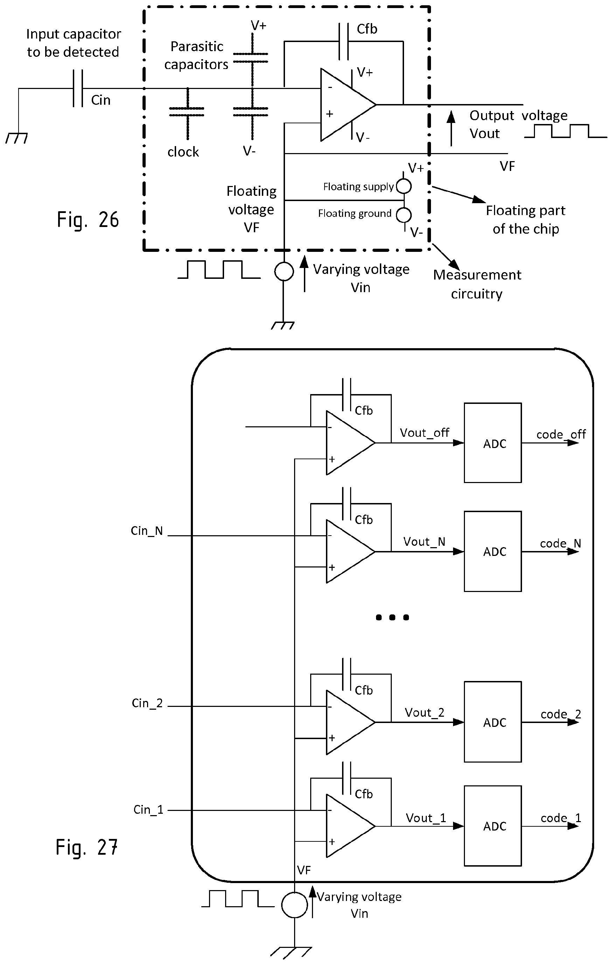

Such examples are illustrated in figure 26. Parasitic capacitors between virtual ground and supply voltages V+ or V- of the charge amplifier, or between virtual ground and a clock signal, may modify the charge on the feedback capacitor, hence the output voltage. As these nodes (supplies or clocks) are common to all the channels, the channels will all be affected in the same way. Assuming for instance a perturbation of amplitude $\Delta V$ on V+ or V- or a clock edge of amplitude $\Delta V$, injected through a capacitor Cpar into the virtual ground node, the output voltage of the charge amplifier is modified by an amount equal to $\Delta Vout = Cpar \cdot \Delta V/Cfb$. Referred to the input capacitor, this corresponds to an error equal to $Coff = Cpar \cdot \Delta V/Vref$, with Vref being the voltage step applied between floating voltage VF and external ground, thus the voltage variation on input capacitors. If this error Coff is constant with time, it corresponds to a systematic offset on all the channels. However, if this error is random, for instance varying from one sampling cycle to another one, it corresponds to a common noise, being identical for all the channels but not constant in time.

One way to get rid of this common mode offset is to use one channel which is not connected to any external capacitor, for instance by disconnecting it from the pad. We will refer to this channel as the offset channel, with charge amplifier output vout_off and output code code_off, see figure 27.

Indeed, for the different active channels, taking into the input referred offset equivalent to a capacitor Coff, the voltage step at the output of the charge amplifier is given by

$$\Delta Vout\_i = vref \ ( \ Cin\_i - Coff \ )/ \ Cfb,$$

while for the offset channel (with Cin=0), one has

$$\Delta Vout\_off = - \ vref \ Coff \ / \ Cfb$$

At the output of the ADC of each active channel, one has

$$Code\_i = k \ (vref/Vref\_ad) \ ( \ Cin\_i - Coff \ ) \ / \ Cfb,$$

while the offset channel provides

$$Code\_off = - \ k \ (vref/Vref\_ad) \ Coff \ / \ Cfb$$

The systematic offset or common noise can then be compensated for by subtracting from the result on any active channel the result from the offset channel. This can be done either in the analog or in the digital domain.
In the analog domain, subtracting the voltage edges on Vout_i and Vout_off, one has

$$\Delta Vout\_i \ - \Delta Vout\_off \ = vref \ Cin\_i \ / \ Cfb,$$

while in the digital domain, subtracting the code of the offset channel from the code of the other channels, one has

$$Code\_i \ - Code\_off = k \ (vref/Vref\_ad) \ Cin\_i / Cfb.$$

In each case, the term corresponding to offset or common mode noise has been removed.

Compensation of Gain and Offset

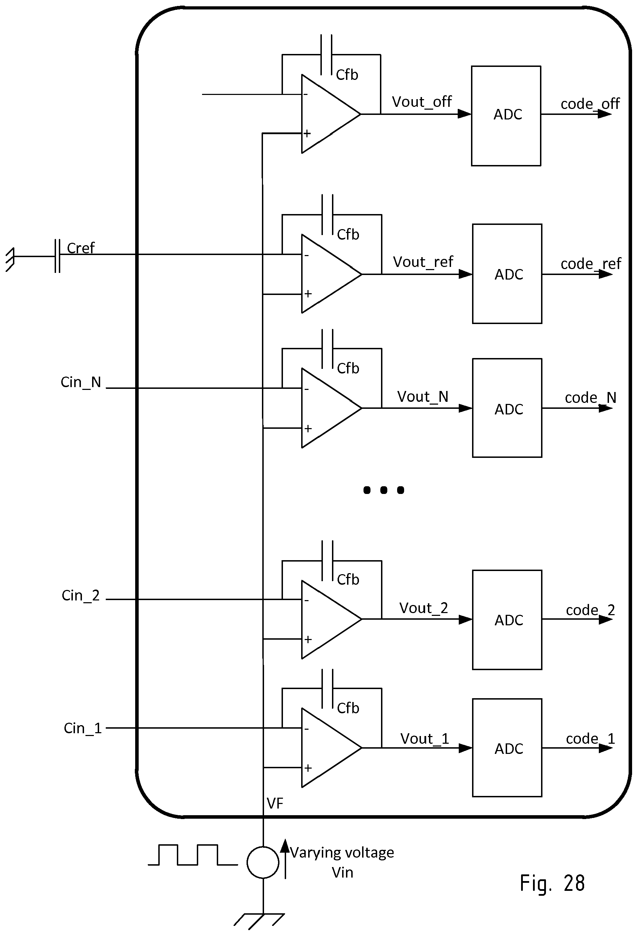

It is also possible to combine both gain and offset compensations, by sacrificing two channels, one connected to a reference capacitor Cref as in figure 3, and one disconnected from any capacitor as in figure 6. The result is given in figure 28.
The offset and gain can then be compensated by first subtracting from every channel, including the reference channel, the result from the offset channel, and then dividing by the corrected result (ref - off) from the reference channel.
Considering for instance the digital results, the relation between input capacitor and output code is given by

$$Code \ = k \ (vref/Vref\_ad) \ (Cin \ - \ Coff) \ / \ Cfb.$$

Thus for every active channel, wich Cin = Cin_i:

$$Code\_i = k \ (vref/Vref\_ad) \ (Cin\_i - \ Coff) \ / \ Cfb,$$

while for the offset channel (Cin=0), one has

$$Code\_off = - \ k \ (vref/Vref\_ad) \ Coff \ / \ Cfb,$$

and for the reference channel (Cin=Cref), one has

$$Code\_ref \ = k \ (vref/Vref\_ad) \ (Cref \ - \ Coff) \ / \ Cfb.$$

The code on each channel can then be compensated in gain and offset by performing the operation

$$(code\_i - code\_off) \ / \ (code\_ref - code\_off)$$

as

$$code\_i - code\_off = k \ (vref/Vref\_ad) \ Cin\_i \ / \ Cfb$$

and

$$code\_ref - code\_off = k \ (vref/Vref\_ad) \ Cref \ / \ Cfb$$

which yields

$$(code\_i - code\_off) \ / \ (code\_ref - code\_off) \ = \ Cin\_i \ / \ Cref.$$

irrespective from common mode offset and of the internal reference voltages. This operation corresponds to a linear interpolation between code_off, corresponding to Cin=0, and code_ref, corresponding to Cin=Cref.

Without departing from the scope of the invention, similar operations could also be done in the analog domain in order to compensate for offset and gain.

Application to touch screens

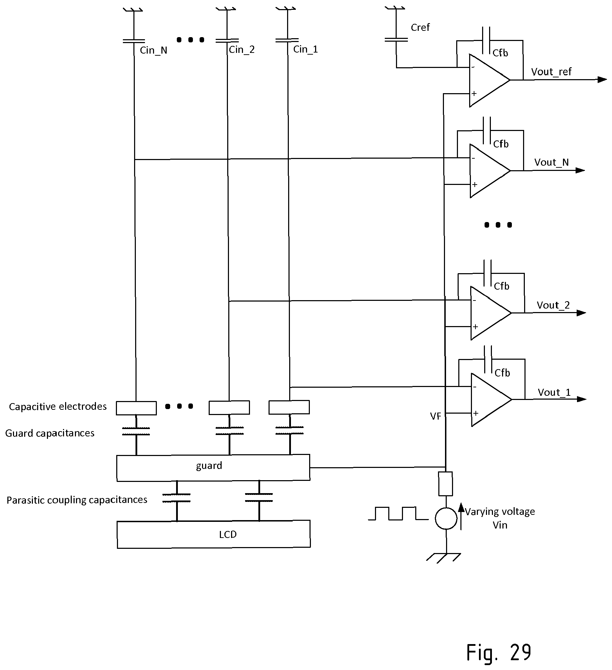

In a touch screen application, typically for smartphones or tablets, the capacitive electrodes the capacitance of which with respect to ground through finger has to be measured are placed on top of an LCD display. However, only the capacitance on the upper side, with respect to fingers, is of interest, while the capacitance with respect to LCD and parasitics signals from LCD are undesirable. For this reason, a conducting guard layer is inserted between the capacitive electrodes and the LCD display, see figure 29

As the capacitive electrodes are tied to negative inputs (virtual grounds) of the charge amplifies, the guard must thus be tied to the voltage VF corresponding to the positive input of the charge amplifier, thus the excitation voltage, on which a well-defined voltage variation vref is applied. Assuming that the charge amplifiers are ideal, both positive and negative are at the same voltage and hence the parasitic capacitors between capacitive electrodes and guard exhibit no voltage variation and transfer no charge.

The guard electrode, also corresponding to the non-inverting input of charge amplifier, thus also acts as a reference electrode, as voltage variation of well-defined amplitude vref are applied through the excitation voltage source.

However practically the excitation voltage source may be noisy, namely due to thermal noise and 1/f noise of transistors used to generate or buffer this voltage, and due to other noise sources.

Moreover, assuming that this excitation voltage source has a non-zero impedance, then the guard will be polluted by the parasitic coupling capacitors between LCD and guard. This will also be seen as a noise on guard voltage. In order to keep this noise sources low, a very low impedance and low noise amplifier is required in order to drive the guard, which requires a high current consumption.

The advantage of the present invention is that all noise sources polluting the VF node (guard voltage), and in particular the coupling to the LCD, are taken into account and compensated for by measuring the effective reference voltage variation on the guard through a channel with reference capacitor with respect to ground, and making the ratio of measurement of any other channel over the measurement of the channel with reference capacitor, as already described in the previous chapter.

**Claims**

1.  A measuring circuit for a proximity sensor, comprising a measure terminal connectable to a capacity that is variable in response to proximity to conductive bodies; a charge amplifier having an input connected to the measure terminal and a reference node connected to a variable reference voltage, a variable voltage source (Vin), connected between a ground voltage and said variable reference voltage and generating a variable voltage (VF) comprising voltage steps such that the charge amplifier is floating with respect to the ground by a voltage (VF) equal to the output of the variable voltage source, and a measurement circuit **characterized by** a sampling unit arranged for sampling the output of the charge amplifier at time instants (T1, T2, T3, T4) synchronised with the variable voltage source (Vin), in such a manner that the output of the charge amplifier is sampled before and after a voltage step, the measuring circuit being arranged for determining an estimation of the capacity connected to the measure terminal based on said sampled output of the charge amplifier.

2. The measuring circuit of the preceding claim, wherein said variable voltage source (Vin) generates a square waveform (VF).

3. The measuring circuit of any of the preceding claims, the measurement circuit being arranged to compare the samples taken before and after a voltage step and determine an estimated value for the step height.

4. The measuring circuit of claim 1, wherein said variable voltage (VF) exhibits rising and/or falling voltage steps of the same height, the measurement circuit being arranged to sample the output of the charge amplifier before and after a plurality of voltage steps, and to compute an average value for the step height.

5. The measuring circuit of the previous claim, comprising analog or digital sampling means for sampling the output of the charge amplifier.

6. The measuring circuit of any of the preceding claims, further including at least one reset switch in a feedback path of the charge amplifier to reset an output voltage of the charge amplifier, the measuring circuit being operatively arranged to activate the reset switch at intervals synchronised with the variable voltage source.

7. The measuring circuit of the preceding claim, wherein the output value of the charge amplifier is reset to a value dependent on the direction and/or the amplitude of the modulation steps generated by the variable voltage source.

8. The measuring circuit of any of the preceding claims, wherein said variable voltage (VF) exhibits rising and/or falling voltage steps of the same height, the measurement circuit being arranged to sample the output of the charge amplifier before and after a plurality of voltage steps, and to compute differences between the heights of the steps, and to determine an estimation of ambient noise based on said differences.

9. The measuring circuit of any of the preceding claims, comprising a sigma-delta or incremental A/D converter arranged to produce a digital code yielding a measure of the average height of the voltage steps.

10. The measuring circuit of claim 10, comprising a sigma-delta converter having an integrator, wherein the integrator of the sigma-delta modulator is reset to a predetermined state at intervals synchronised with the variable voltage source.

11. The measuring circuit of claim 10, comprising a sigma-delta converter having an integrator, wherein the state of integrator of the sigma-delta modulator is sampled and quantized in order to increase the resolution of the digital code yielding a measure of the average height.

12. The measuring circuit of any of the preceding claims, comprising one or more test capacitors, and a switching unit driveable to connect one or more test capacitors to the measure terminal for testing the measuring circuit.

13. The measuring circuit of any of the preceding claims, comprising a floating unipolar or bipolar power supply for the charge amplifier.

14. The measuring circuit of the previous claim, in which said floating power supply includes at least a flying capacitor, driven by a switching signal that is synchronised with the variable voltage source.

15. The measuring circuit of one of the two previous claims, in which the flying capacitor of the floating supply voltage is switched in a cycle comprising a charge phase, in which the flying capacitor is tied to a power supply and a supply phase in which the flying capacitor is isolated from said power supply and connected to the floating power supply.

16. The measuring circuit of one of the preceding claims, wherein the variable voltage source is capable of being set in a high-impedance state.

17. A measuring system comprising two or several measuring circuits according to the preceding claims, each connected to a variable capacity or to a group of variable capacities, arranged to become active sequentially and one at a time for measuring the capacities connected at the respective inputs, whereby the variable voltage source of the active circuit determines the variable voltage VF, and the variable voltage sources of the circuits that are not active are set in the high-impedance state.

18. A measuring system comprising two or several measuring circuits according to one of claims from 1 to 16, wherein the input of one measuring circuit is connected to a reference capacitor for gain compensation, and/or the input of one measuring circuit is left not connected for offset compensation, and the inputs of other circuits are connected to a variable capacity or to a group of variable capacities.

**Patentansprüche**

1. Messschaltung für einen Näherungssensor, umfassend einen Messanschluss, der mit einer Kapazität verbindbar ist, die in Reaktion auf die Nähe zu leitenden Körpern variabel ist; einen Ladungsverstärker mit einem Eingang, der mit dem Messanschluss verbunden ist, und einem Referenzknoten, der mit einer variablen Referenzspannung verbunden ist, einer variablen Spannungsquelle (Vin), die zwischen einer Massespannung und der besagten variablen Referenzspannung geschaltet ist und eine variable Spannung (VF) erzeugt, umfassend Spannungsstufen derart, dass der Ladungsverstärker bezüglich der Masse um eine dem Ausgang der variablen Spannungsquelle entsprechenden Spannung (VF) potentialfrei ist, und eine Messschaltung, durch eine Abtasteinheit gekennzeichnet, die zum Abtasten des Ausgangs des Ladungsverstärkers zu mit der variablen Spannungsquelle (Vin) synchronisierten Zeitpunkten (T1, T2, T3, T4) derart angeordnet ist, dass der Ausgang des Ladungsverstärkers vor und nach einer Spannungsstufe abgetastet wird, wobei die Messschaltung zur Ermittlung einer Schätzung der mit dem Messanschluss verbundenen Kapazität auf der Basis des besagten abgetasteten Ausgangs des Ladungsverstärkers angeordnet ist.

2. Messschaltung gemäss dem vorhergehenden Anspruch, worin die besagte variable Spannungsquelle (Vin) eine Rechteckwellenform (VF) erzeugt.

3. Messschaltung gemäss irgendeinem der vorhergehenden Ansprüche, wobei die Messschaltung angeordnet ist, um die vor und nach einer Spannungsstufe genommenen Proben zu vergleichen und einen geschätzten Wert für die Stufenhöhe zu bestimmen.

4. Messschaltung gemäss Anspruch 1, worin die besagte variable Spannung (VF) ansteigende und/oder fallende Spannungsstufen gleicher Höhe aufweist, wobei die Messschaltung angeordnet ist, um den Ausgang des Ladungsverstärkers vor und nach mehreren Spannungsstufen abzutasten, und um einen Durchschnittswert für die Stufenhöhe zu berechnen.

5. Messschaltung gemäss dem vorhergehenden Anspruch, umfassend analoge oder digitale Abtastmittel zum Abtasten des Ausgangs des Ladungsverstärkers.

6. Messschaltung gemäss irgendeinem der vorhergehenden Ansprüche, zudem mit mindestens einem Rücksetzschalter in einem Rückkopplungsweg des Ladungsverstärkers, um eine Ausgangsspannung des Ladungsverstärkers zurückzusetzen, wobei die Messschaltung operativ angeordnet ist, um den Rücksetzschalter in mit der variablen Spannungsquelle synchronisierten Intervallen zu aktivieren.

7. Messschaltung gemäss dem vorhergehenden Anspruch, worin der Ausgangswert des Ladungsverstärkers auf einen Wert zurückgesetzt wird, der von der Richtung und/oder der Amplitude der von der variablen Spannungsquelle erzeugten Modulationsstufen abhängt.

8. Messschaltung gemäss irgendeinem der vorhergehenden Ansprüche, worin die besagte variable Spannung (VF) ansteigende und/oder fallende Spannungsstufen gleicher Höhe aufweist, wobei die Messschaltung derart angeordnet ist, um den Ausgang des Ladungsverstärkers vor und nach einer Vielzahl von Spannungsstufen abzutasten, und um Unterschiede zwischen den Höhen der Stufen zu berechnen, und um eine Schätzung vom Umgebungsgeräusch basierend auf den besagten Unterschieden zu bestimmen.

9. Messschaltung gemäss irgendeinem der vorhergehenden Ansprüche, umfassend einen Sigma-Delta oder Inkremental-A/D-Wandler, der angeordnet ist, um einen digitalen Code zu erzeugen, der eine Messung für die durchschnittliche Höhe der Spannungsstufen liefert.

10. Messschaltung gemäss Anspruch 10, umfassend einen Sigma-Delta-Wandler mit einem Integrator, worin der Integrator des Sigma-Delta-Modulators in mit der variablen Spannungsquelle synchronisierten Intervallen auf einen vorbestimmten Zustand zurückgesetzt wird.

11. Messschaltung gemäss Anspruch 10, umfassend einen Sigma-Delta-Wandler mit einem Integrator, worin der Integratorzustand des Sigma-Delta-Modulators abgetastet und quantisiert wird, um die Auflösung des digitalen Codes zu erhöhen, der eine Messung für die durchschnittliche Höhe der Spannungsstufen liefert.

12. Messschaltung gemäss irgendeinem der vorhergehenden Ansprüche, umfassend einen oder mehrere Testkondensatoren und eine Schalteinheit, die zum Verbinden eines oder mehrerer Testkondensatoren mit dem Messanschluss zum Testen der Messschaltung ansteuerbar ist.

13. Messschaltung gemäss irgendeinem der vorhergehenden Ansprüche, mit einer potentialfreien unipolaren oder bipolaren Stromversorgung für den Ladungsverstärker.

14. Messschaltung gemäss dem vorhergehenden Anspruch, worin die besagte potentialfreie Stromversorgung mindestens einen fliegenden Kondensator umfasst, der von einem Schaltsignal angesteuert wird, das mit der variablen Spannungsquelle synchronisiert ist.

15. Messschaltung gemäss einem der beiden vorhergehenden Ansprüche, worin der fliegende Kondensator der potentialfreien Versorgungsspannung in einem Zyklus geschaltet ist, der eine Ladephase umfasst, in welcher der fliegende Kondensator an eine Stromversorgung verbunden ist, und eine Versorgungsphase, in welcher der fliegende Kondensator von der besagten Stromversorgung isoliert ist und mit der potentialfreien Stromversorgung verbunden ist.

16. Messschaltung gemäss einem der vorhergehenden Ansprüche, worin die variable Spannungsquelle in einen hochohmigen Zustand versetzt werden kann.

17. Messsystem mit zwei oder mehreren Messschaltungen gemäss den vorhergehenden Ansprüchen, die jeweils mit einer veränderlichen Kapazität oder einer Gruppe veränderlicher Kapazitäten verbunden sind, so angeordnet, dass sie sequentiell und eine nach der anderen zur Messung der an ihren jeweiligen Eingängen angeschlossenen Kapazitäten aktiv werden, wobei die variable Spannungsquelle der aktiven Schaltung die variable Spannung VF bestimmt, und die variablen Spannungsquellen der Schaltungen, die nicht aktiv sind, in den hochohmigen Zustand versetzt werden.

18. Messsystem mit zwei oder mehreren Messschaltungen gemäss einem der Ansprüche 1 bis 16, worin der Eingang einer Messschaltung zwecks Kompensation der Verstärkung mit einem Referenzkondensator verbunden ist, und/oder der Eingang einer Messschaltung zwecks Offset-Kompensation nicht angeschlossen bleibt, und die Eingänge anderer Schaltungen mit einer variablen Kapazität oder einer Gruppe variabler Kapazitäten verbunden sind.

**Revendications**

1. Circuit de mesure pour un capteur de proximité, comprenant une borne de mesure connectable à une capacité qui est variable en réponse à la proximité de corps conducteurs; un amplificateur de charge ayant une entrée reliée à la borne de mesure et un noeud de référence relié à une tension de référence variable, une source de tension variable (Vin) reliée entre une tension de masse et ladite tension de référence variable et générant une tension variable (VF) comprenant des pas de voltage de telle sorte que l'amplificateur de charge flotte par rapport à la masse par une tension (VF) égale à la sortie de la source de tension variable, et un circuit de mesure **caractérisé par** une unité d'échantillonnage agencée pour échantillonner la sortie de l'amplificateur de charge à des instants temporels (T1, T2, T3, T4) synchronisés avec la source de tension variable (Vin), de telle sorte que la sortie de l'amplificateur de charge est échantillonnée avant et après un pas de tension, le circuit de mesure étant agencé pour déterminer une estimation de la capacité connectée à la borne de mesure sur la base de ladite sortie échantillonnée de l'amplificateur de charge.

2. Circuit de mesure selon la revendication précédente, dans lequel ladite source de tension variable (Vin) génère une forme d'onde carrée (VF).

3. Circuit de mesure selon l'une quelconque des revendications précédentes, le circuit de mesure étant agencé pour comparer les échantillons prélevés avant et après un pas de tension et pour déterminer une valeur estimée pour la hauteur de pas.

4. Circuit de mesure selon la revendication 1, dans lequel ladite tension variable (VF) présente des pas de tension montante et/ou descendante de même hauteur, le circuit de mesure étant agencé pour échantillonner la sortie de l'amplificateur de charge avant et après une pluralité de pas de tension, et pour calculer une valeur moyenne pour la hauteur de pas.

5. Circuit de mesure selon la revendication précédente, comprenant des moyens d'échantillonnage analogique ou numérique pour échantillonner la sortie de l'amplificateur de charge.

6. Circuit de mesure selon l'une quelconque des revendications précédentes, comprenant en outre au moins un commutateur de réinitialisation dans un chemin de rétroaction de l'amplificateur de charge pour réinitialiser une tension de sortie de l'amplificateur de charge, le circuit de mesure étant agencé de manière fonctionnelle pour activer le commutateur de réinitialisation à des intervalles synchronisés avec la source de tension variable.

7. Circuit de mesure selon la revendication précédente, dans lequel la valeur de sortie de l'amplificateur de charge est réinitialisée à une valeur dépendant de la direction et/ou de l'amplitude des étapes de modulation générées par la source de tension variable.

8. Circuit de mesure selon l'une quelconque des revendications précédentes, dans lequel ladite tension variable (VF) présente des pas de tension montante et/ou descendante de même hauteur, le circuit de mesure étant agencé pour échantillonner la sortie de l'amplificateur de charge avant et après une pluralité de pas de tension, et pour calculer les différences entre les hauteurs des pas, et pour déterminer une estimation du bruit ambiant sur la base desdites différences.

9. Circuit de mesure selon l'une quelconque des revendications précédentes, comprenant un convertisseur A/N sigma-delta ou incrémental agencé pour produire un code numérique donnant une mesure de la hauteur moyenne des pas de tension.

10. Circuit de mesure selon la revendication 10, comprenant un convertisseur sigma-delta ayant un intégrateur, dans lequel l'intégrateur du modulateur sigma-delta est réinitialisé à un état prédéterminé à des intervalles synchronisés avec la source de tension variable.

11. Circuit de mesure selon la revendication 10, comprenant un convertisseur sigma-delta ayant un intégrateur, dans lequel l'état de l'intégrateur du modulateur sigma-delta est échantillonné et quantifié afin d'augmenter la résolution du code numérique donnant une mesure de la hauteur moyenne.

12. Circuit de mesure selon l'une quelconque des revendications précédentes, comprenant un ou plusieurs condensateurs de test, et une unité de commutation pouvant être commandée pour connecter un ou plusieurs condensateurs de test à la borne de mesure pour tester le circuit de mesure.

13. Circuit de mesure selon l'une quelconque des revendications précédentes, comprenant une alimentation électrique unipolaire ou bipolaire flottante pour l'amplificateur de charge.

14. Circuit de mesure selon la revendication précédente, dans lequel ladite alimentation électrique flottante comprend au moins un condensateur volant, entraîné par un signal de commutation qui est synchronisé avec la source de tension variable.

15. Circuit de mesure selon l'une des deux revendications précédentes, dans lequel le condensateur volant de la tension d'alimentation flottante est commuté dans un cycle comprenant une phase de charge, dans laquelle le condensateur volant est relié à une alimentation électrique, et une phase d'alimentation, dans laquelle le condensateur volant est isolé de ladite alimentation électrique et connecté à l'alimentation électrique flottante.

16. Circuit de mesure selon l'une des revendications précédentes, dans lequel la source de tension variable peut être mise dans un état de haute impédance.

17. Système de mesure comprenant deux ou plusieurs circuits de mesure selon les revendications précédentes, chacun relié à une capacité variable ou à un groupe de capacités variables, agencé pour devenir actif séquentiellement et un à la fois pour mesurer les capacités connectées aux entrées respectives, la source de tension variable du circuit actif déterminant la tension variable VF, et les sources de tension variables des circuits qui ne sont pas actifs sont mises dans l'état de haute impédance.

18. Système de mesure comprenant deux ou plusieurs circuits de mesure selon l'une des revendications 1 à 16, dans lequel l'entrée d'un circuit de mesure est connectée à un condensateur de référence pour compenser le gain, et/ou l'entrée d'un circuit de mesure est laissée non connectée pour compensation d'offset, et les entrées d'autres circuits sont connectées à une capacité variable ou à un groupe de capacités variables.

PRIOR ART

Fig.1

PRIOR ART

Fig.2

Fig.3

PRIOR ART

Input capacitor to be detected

Cin

Cfb

V+

V-

+

Cpar

Floating supply

Floating ground

Floating voltage VF

V+

V-

Varying voltage Vin

Output voltage Vout

Floating part of the chip

Measurement circuitry

EP 2 876 407 B1

Fig.4

Fig.5

Input capacitor
to be detected

Cin

Cfb

V+

V-

Output voltage
Vout

VF

Floating supply

V+

Floating ground

V-

Floating
voltage
VF

Varying voltage
Vin
(square wave)

Floating part
of the chip

Measurement
circuitry

EP 2 876 407 B1

## Fig.6a

Input capacitor to be detected

Cfb

Cin

V+
V-

Floating part of the chip

Perturbating voltage Vpert

Floating voltage VF

Output voltage Vout

VF

Varying voltage Vin (square wave)

## Fig.6b

Vin

Vin high

Vin low

Vout

delta_T

delta_T

time

T1    T2    T3    T4

Tmod/2

EP 2 876 407 B1

Fig.7b

Fig.7d

Idcfb – gmfb (vout–Vout_DC)

Fig.7a

Fig.7c

EP 2 876 407 B1

Fig.8

Rfb

Cfb

Cin

Vvirt

V+

Vout

V-

VF

Vperturbation
220 V RMS
50Hz

Vin

V+

output range
= 2 V

V-

Fig.9b

Fig.9d

Fig.9a

Fig.9c

Fig.10

EP 2 876 407 B1

Fig.11

reset

Vin

Vin high

Vin low

Vout

Vinit_high

Vinit_low

Vinit_low

Vin high

Vinit_high

time

T1    T2    T3    T4

EP 2 876 407 B1

31

Fig.12a

Fig.12c

Fig.12b

Fig.13a

Fig.13b

Cfb

Vout

Charge
amplifier

Rising/falling edges → Analog averaging → Analog to Digital conversion → Average Output code

Fig.14

Cfb

Vout

Charge
amplifier

Rising/falling edges → Analog to Digital conversion → Digital codes → Digital averaging → Average Output code

Fig.15

Fig.16

Fig.17

Fig.18

EP 2 876 407 B1

Fig.19a

Fig.19b

Fig. 20

Fig. 21a

Fig. 21b

Fig. 21c

Fig. 22a

Fig. 22b

Cin_N

Cfb

Vout_N

ADC

code_N

Fig. 23

Cfb

Cin_2

Vout_2

ADC

code_2

Cfb

Cin_1

Vout_1

ADC

code_1

VF

Varying voltage
Vin

Cref

Cfb

Vout_ref

ADC

code_ref

Cin_N

Cfb

Vout_N

ADC

code_N

Cin_2

Cfb

Vout_2

ADC

code_2

Cin_1

Cfb

Vout_1

ADC

code_1

VF

Fig. 24

Varying voltage
Vin

Fig. 25

**Fig. 26**

Input capacitor to be detected

Parasitic capacitors

Cin

clock

V+

V-

Cfb

V+

V-

Output voltage
Vout

VF

Floating voltage
VF

Floating supply    V+

Floating ground    V-

Floating part
of the chip

Measurement
circuitry

Varying voltage
Vin

**Fig. 27**

Cfb

Vout_off

ADC

code_off

Cin_N

Cfb

Vout_N

ADC

code_N

• • •

Cin_2

Cfb

Vout_2

ADC

code_2

Cin_1

Cfb

Vout_1

ADC

code_1

VF

Varying voltage
Vin

Fig. 28

Fig. 29

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2756048
- US 2010110040 A
- US 6239788 B
- US 3761805 A
- WO 0005593 A